Europäisches Patentamt

European Patent Office

Office européen des brevets

(19)

(11) **EP 1 291 680 A2**

(12) **EUROPEAN PATENT APPLICATION**

(43) Date of publication:
**12.03.2003 Bulletin 2003/11**

(51) Int Cl.⁷: **G02B 5/08**, B29D 11/00

(21) Application number: **02255926.4**

(22) Date of filing: **27.08.2002**

| | |
|---|---|
| (84) Designated Contracting States:<br>**AT BE BG CH CY CZ DE DK EE ES FI FR GB GR IE IT LI LU MC NL PT SE SK TR**<br>Designated Extension States:<br>**AL LT LV MK RO SI**<br><br>(30) Priority: **27.08.2001 JP 2001255983**<br>**03.09.2001 JP 2001266148**<br>**05.09.2001 JP 2001268322**<br>**13.09.2001 JP 2001277808**<br>**13.09.2001 JP 2001277810**<br><br>(71) Applicant: **Nikon Corporation**<br>**Tokyo 140-8601 (JP)**<br><br>(72) Inventors:<br>• **Kandaka, Noriaki**<br>**Chiyoda-ku, Tokyo 100-8331 (JP)** | • **Murakami, Katsuhiko**<br>**Chiyoda-ku, Tokyo 100-8331 (JP)**<br>• **Komatsuda, Hideki**<br>**Chiyoda-ku, Tokyo 100 (JP)**<br>• **Ishiyama, Wakana**<br>**Chiyoda-ku, Tokyo 100 (JP)**<br>• **Shiraishi, Masayuki**<br>**Chiyoda-ku, Tokyo 100 (JP)**<br>• **Sugisaki, Katsumi**<br>**Chiyoda-ku, Tokyo 100 (JP)**<br>• **Yamamoto, Masaki**<br>**Chiyoda-ku, Tokyo 100 (JP)**<br><br>(74) Representative: **Meddle, Alan Leonard et al**<br>**Forrester & Boehmert**<br>**Pettenkoferstrasse 20-22**<br>**80336 München (DE)** |

(54) **Multilayer-film mirrors for use in extreme UV optical systems, and methods for manufacturing such mirrors exhibiting improved wave aberrations**

(57)   An apparatus for removing one or more surficial layers of a multilayer film on a multilayer-film mirror so as to correct a wave-front produced by the multilayer-film mirror, the multilayer film comprising multiple alternating layers of at least a first layer-material and a second layer-material having mutually different refractive indices with respect to a prescribed wavelength, the apparatus comprising: a layer-removal device situated and configured to remove at least a respective portion of one or more surficial layers of the multilayer film; and an analysis device situated and configured to analyse at least one of the removed layer-materials.

FIG. 1

EP 1 291 680 A2

**Description**

<u>Field</u>

This disclosure pertains to multilayer-film reflective mirrors as used in optical systems for "soft" X-ray (extreme ultraviolet, or EUV) wavelengths of light. These mirrors, and optical systems comprising them, are especially useful in microlithography methods and apparatus for use with EUV light. EUV microlithography is an important "next generation" microlithography technique showing great promise for use in the fabrication of microelectronic devices such as semiconductor integrated circuits, displays, and the like. The disclosure also pertains to methods for manufacturing multilayer-film mirrors, the methods producing multilayer-film mirrors exhibiting improved correction of wave aberrations.

<u>Background</u>

In recent years, as the size of active circuit elements in microelectronic devices (such as semiconductor integrated circuits) has continued to decrease with concomitant increases in circuit density, the pattern-resolution limitations of optical microlithography (lithography performed using ultraviolet light) have become increasingly apparent. Consequently, substantial research effort is being expended to develop a practical "next generation" microlithography (NGL) technology capable of achieving substantially increased resolution compared to optical microlithography.

An especially promising NGL technology is projection microlithography that utilizes "soft" X-rays having a wavelength in the range of approximately 11 to 14 nm. See Tichenor et al., *Proceedings SPIE* **2437**:292 (1995). Recently, soft X-ray microlithography has been termed Extreme Ultraviolet (EUV) Lithography (abbreviated EUVL), which is the term used herein. EUVL is capable of resolving pattern line-widths of 70 nm or less, which currently is not achievable using conventional optical microlithography that utilizes a wavelength of approximately 190 nm or more.

With respect to the EUVL wavelength range of 11-14 nm, all known materials usable for making optical elements have refractive indices extremely close to unity (1) and exhibit extremely low reflectivity to such wavelengths at low angles of incidence. As a result, conventional optical elements such as lenses (refractive elements) and mirrors (reflective elements) usable with longer wavelengths of electromagnetic radiation cannot be used. Rather, EUVL optical elements are configured either as grazing-incidence mirrors or multilayer-film-reflective mirrors (multilayer-film mirrors).

Grazing-incidence mirrors exploit total reflection of EUV radiation, at very high angles of incidence, from a surface of a material having a refractive index slightly smaller than unity. Since optical systems comprising grazing-incidence mirrors exhibit relatively high aberration, such systems usually cannot achieve diffraction-limit resolution in a wide optical field. As a result, in EUVL apparatus, grazing-incidence mirrors are not used for projecting pattern images, but can be used for pattern illumination on a reticle (see below).

Multilayer-film mirrors can reflect EUV radiation incident perpendicularly to the mirror surface, and are usable in diffraction-limited EUV optical systems. Hence, multilayer-film mirrors can be used for projection of a pattern image (see below). By constructive interference, multilayer-film mirrors align and superpose phases of EUV light weakly reflected from many thin-film interfaces in the multilayer film on the mirror surface to obtain high overall reflectivity. To achieve the highest possible reflectivity, the multilayer film is formed of alternating layers of a first material exhibiting a relatively large difference in refractive index compared to a vacuum, and a second material exhibiting a relatively small difference in refractive index compared to a vacuum.

A multilayer-film mirror comprises a surficial multilayer film formed on a "reflection surface" of a mirror substrate. The "reflection surface" is the surface (usually shaped by grinding and polishing to have a curved profile, such as a spherical or aspherical profile) of the mirror substrate destined to receive the multilayer film. The mirror substrate normally is quartz or a glass material that exhibits an extremely low coefficient of thermal expansion, has low surface roughness, and that can be profiled with high accuracy. A multilayer-film mirror in which the multilayer film consists of alternating layers of molybdenum (Mo) and silicon (Si) exhibits maximal reflectivity (approximately 70%) when used with an EUV wavelength longer than the L absorption peak (12.3 nm) of silicon. Nevertheless, within the wavelength range of 13 to 15 nm, the reflectivity does not exceed approximately 70% regardless of the angle of incidence of EUV radiation.

As a specific example, a multilayer-film mirror having a Mo/Si multilayer film exhibits a reflectivity of approximately 67.5% to EUV radiation having a wavelength of approximately 13.4 nm directly incident on the surface of the multilayer film. As another example, a multilayer-film mirror having a Mo/Be multilayer film, in which Mo and beryllium (Be) layers are laminated in an alternating manner, exhibits a reflectivity of approximately 70.2% to EUV radiation having a wavelength of approximately 11.3 nm directly incident on the surface of the multilayer film. See, *e.g.,* Montcalm, *Proceedings SPIE* **3331**:42 (1998).

An EUVL apparatus mainly comprises an EUV light source, an illumination-optical system, a reticle (mask) stage, an image-formation optical system (also termed "projection-optical system"), and a substrate (wafer) stage. The EUV light source can be a laser-plasma light source, a discharge-plasma light source, or a radiation source such as an "SOR" (synchrotron orbit radiation) source. The illumination-optical system typically comprises multiple grazing-incidence mirrors each highly reflective to an EUV beam incident to the mirror surface at a very high angle of incidence. The illumination-optical system also includes one or more filters that transmit only EUV radiation of a prescribed wavelength. Thus, the reticle is illuminated only by EUV radiation of a desired wavelength. Because no known materials exist that are transparent to EUV radiation and suitable for making a reticle, the reticle used in an EUVL apparatus is a reflective-type reticle rather than a conventional transparent reticle.

The EUVL apparatus transfers an image of a circuit pattern, defined on the reticle, to a "sensitive" substrate (*e.g.,* semiconductor wafer coated with a suitable resist) that is imprintable with the pattern whenever the pattern is projected by the EUVL apparatus onto the resist surface). The image is projected onto the wafer surface by the image-formation optical system. As noted above, for better control of aberrations, the image-formation optical system comprises multiple multilayer-film mirrors rather than grazing-incidence mirrors. Since EUV radiation is absorbed and attenuated in the atmosphere, the image-formation optical system is contained in a chamber evacuated to a suitable prescribed vacuum level *(e.g.,* $1 \times 10^{-5}$ Torr or less). The illumination-optical system also is maintained at a suitable vacuum level.

Since the reflectivity of each multilayer-film mirror in the image-formation optical system is not 100%, the number of such mirrors in this optical system desirably is as small as possible so as to limit the loss of EUV light in the system. In this regard, image-formation optical systems consisting of four multilayer-film mirrors (see, *e.g.,* Jewell et al., U.S. Patent No. 5,315,629 and Jewell, U.S. Patent No. 5,063,586) and six multilayer-film mirrors (see, *e.g.,* Williamson, Japan *Kôkai* Patent Publication No. *Hei* 9-211332 (1997), U.S. Patent No. 5,815,310) have been reported.

In contrast with refractive optical systems in which the luminous flux typically propagates in only one direction, in reflective optical systems the luminous flux has a circuitous propagation path. As a result, it is difficult to achieve a large numerical aperture (NA) in a reflective optical system larger due to the limitation of preventing the mirrors from blocking the luminous flux. For example, in a 4-mirror optical system, a NA of only approximately 0.15 has been achieved. In a 6-mirror optical system, somewhat larger numerical apertures *(e.g.,* 0.25) have been achieved. In any event, the number of multilayer-film mirrors in the optical system usually is an even number so that the reticle stage and wafer stage can be situated on opposing sides of the image-formation optical system.

In the image-formation optical system as summarized above, aberrations need to be corrected, and only a limited number of reflective surfaces are available for achieving aberration correction. Consequently, the reflective surfaces of the multilayer-film mirrors usually have respective aspherical profiles. Also, imaging by the system is performed in a "ring-field" manner, in which aberration is corrected only in the vicinity of a prescribed image height. Thus, in order to transfer the entire pattern from the reticle to the wafer, exposure is performed while scanning the reticle stage and wafer stage at respective velocities that differ from each other according to the magnification of the optical system.

The image-formation optical system summarized above is a so-called "diffraction-limited" optical system that nevertheless cannot achieve design-mandated performance if wave aberrations are not reduced sufficiently. A yardstick of the tolerance value of wave aberration in diffraction-limited optical systems is the Marechal's standard, which states that the root-mean-square (RMS) departure of the wave-front from a reference sphere centered on the diffraction focus shall not exceed the value of $\lambda/14$. Born and Wolf, *Principles of Optics,* 7th edition, Cambridge University Press, p. 528 (1970). Under such a condition the Strehl intensity (ratio of the maximum value of the spot-image intensity of an optical system exhibiting aberration relative to an optical system not exhibiting aberration) is 80% or more. In actual EUVL apparatus, image-formation optical systems typically are manufactured so as to have aberrations lower than these standards so as to satisfy strict requirements such as satisfactory line-width control.

Currently, in EUVL technology on which most research and development is being conducted, wavelengths in the vicinity of 13 nm or 11 nm mainly are used as the EUV exposure wavelength. The form error (FE) permitted in individual multilayer-film mirrors, with respect to the wave aberration (or wave-front error, abbreviated WFE) of the optical system, is obtained by the following equation:

$$FE = WFE/2/m^{1/2} \text{ (RMS)} \qquad (1)$$

wherein m is the number of multilayer-film mirrors in the subject optical system. The reason for dividing by 2 is that, in a reflective optical system, both the incident light and the reflected light are affected by form error, so the wave aberration has twice the error of the form error. As a result, in a diffraction-limited optical system, the form error (FE) allowed in each individual mirror is obtained by the following equation with respect to the wavelength (and m):

$$FE = \lambda/28/m^{1/2} \text{ (RMS)} \qquad (2)$$

At a wavelength of $\lambda$ = 13 nm, FE is 0.23 nm RMS in an optical system comprising m = 4 multilayer-film mirrors and 0.19 nm RMS in an optical system comprising m = 6 multilayer-film mirrors.

However, manufacturing this type of high-precision aspheric mirror is extremely difficult, which is a key reason for which EUVL has not yet been made practical. The aspheric-surface processing precision achievable currently is approximately 0.4 to 0.5 nm RMS. Gwyn, *Extreme Ultraviolet Lithography White Paper,* EUV LLC, p. 17 (1998). Consequently, great improvements in aspheric-surface processing technology and surface-measurement technology are considered necessary in order to make EUVL a reality.

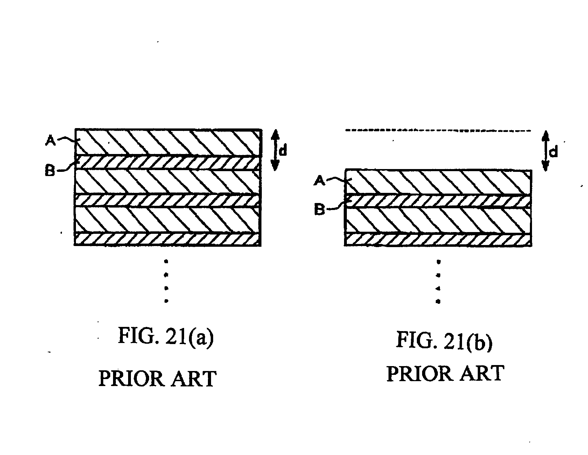

Recently, a landmark technique has been reported that can correct a sub-nm form error effectively. Yamamoto, *7th International Conference on Synchrotron Radiation Instrumentation*, Berlin, Germany, POS2-189, August 21-25, 2000. The technique involves "shaving" off one layer-set at a time from the surface of the multilayer-film mirror, as explained below referring to FIGS. 21(a)-21(b). FIG. 21(a) shows three layer-pairs of a multilayer film applied to the surface of a mirror substrate (not shown). Each layer-pair consists of a layer of material A and a layer of material B. Each layer-pair has a thickness (period length) "d". Note that, in the depicted multilayer film, the layers A, B are arranged in an alternating manner, and the period length d is constant. In FIG. 21(b), the topmost layer-pair has been removed. In FIG. 21(a), the optical-path length of each layer-pair (having a period length d), with respect to a light beam incident perpendicularly to the mirror surface is expressed by:

$$OP = n_A d_A + n_B d_B \qquad (3)$$

wherein $d_A$ and $d_B$ denote respective thicknesses of the layers A and B, $d_A + d_B = d$, and $n_A$ and $n_B$ denote refractive indices of the substances A and B, respectively.

In FIG. 21(b), the optical path length obtained by removing the uppermost pair of layers A, B of the multilayer film (having thickness d) is given by:

$$OP' = n_o d \qquad (4)$$

wherein $n_o$ denotes the refractive index of the vacuum ($n_o$ = 1). Thus, removing the uppermost layer-pair of the multilayer film yields a change in the optical distance over which an incident light beam passes in the multilayer film. From an optical standpoint, this change is equivalent to correcting the surface shape of the mirror effectively by the amount of the change.

The change "$\Delta$" in the optical path length (*i.e.*, the change in the surface shape) is expressed as:

$$\Delta = OP' - OP \qquad (5)$$

In the EUV wavelength range, the refractive index of useful mirror substances is nearly unity. Consequently, $\Delta$ is very small, which allows highly accurate and precise surface-shape correction using this technique. As a specific example, consider a case in which a Mo/Si multilayer-film mirror is used to reflect an EUV wavelength of 13.4 nm. Since the EUV radiation is normally incident (*i.e.*, at an essentially zero angle of incidence) on the multilayer-film surface, d = 6.8 nm, $d_{Mo}$ = 2.3 nm, and $d_{Si}$ = 4.5 nm. The refractive indices at these wavelengths are $n_{Mo}$ = 0.92, and $n_{Si}$ = 0.998. Calculating the change in optical path length using these figures yields: OP = 6.6 nm, OP' = 6.8 nm, and $\Delta$ = 0.2 nm. Thus, a 0.2-nm correction of the surface shape can be performed by removing a 6.8-nm thick layer-pair.

In the case of a Mo/Si multilayer film, the refractive index of the Si layer to EUV radiation is nearly unity, while Mo exhibits a refractive index that differs from unity more than Si. Consequently, a change in the optical-path length resulting from removing the uppermost layer-pair mainly depends upon removing the Mo layer rather than the Si layer. Hence, when removing a surficial layer-pair of the multilayer film, it is not necessary to control the thickness of the Si layer accurately. For example, with a Si-layer thickness of 4.5 nm, removal of a surficial layer-pair can be stopped at mid-thickness of the Si layer.

In actual practice, reflection wave-fronts are measured after forming the multilayer film on the mirror. The amount of layer-removal to be performed is determined based on the results of such measurements. In any event, by performing layer-removal processing to an accuracy of several nm, it is possible to perform surface-shape correction to an accuracy of 0.2 nm.

Note that the reflectivity of a multilayer film increases with an increase in the number of layer-pair laminations. The reflectivity becomes saturated and constant whenever the number of layer-pairs exceeds a predetermined minimum number of layer-pairs required for maximal reflectivity. If a number of layers sufficient to saturate reflectivity is laminated in advance, then no change in reflectivity of the mirror will result even if a portion of the multilayer-film were removed from the surface of the mirror.

Also, in general, multilayer films have internal stress. Hence, forming a multilayer film on the surface of a mirror substrate can cause subtle changes in the surface profile of the mirror substrate as a result of the internal stress of the multilayer film. Similarly, removing one or more layers from the multilayer film can change the internal stress and cause a subtle (but nevertheless significant) change in the surface profile. Hence, by reducing internal stress (e.g., by configuring each unit lamination structure as Mo/Ru/Mo/Si rather than Mo/Si), the change in the substrate-surface profile caused by forming or removing portions of the multilayer film can be reduced.

Lens-polishing techniques can be used for removing layers from a multilayer film. In this technique, a polishing liquid containing a polishing agent is applied to a soft, relatively small, sponge-like polishing surface. The polishing surface is urged against the region of the mirror surface from which one or more layer-pairs are to be removed. Thus, local layer-removal is performed a little at a time. Alternative techniques include Ion Beam Machining (IBM) and Chemical Vapor Machining (CVM). In IBM, for example, local layer-removal is performed by irradiating a narrowly focused ion beam onto the desired location on the mirror surface. This alternative technique is performed in a vacuum chamber evacuated to a suitably low vacuum level.

The Yamamoto technique for achieving wave-front correction is extremely effective. However, this technique as conventionally performed has several problems associated with it, as summarized below.

First, accurate control of the amount of material locally removed is necessary. Even though the accuracy and precision required for layer-removal processing is not as strict as the wave-front accuracy that must be exhibited by the mirror, control at an accuracy of several nm nevertheless is required during layer-removal. Measurement of the profile of the reflective surface of the mirror normally is performed interferometrically. But, in order to perform profile measurements on a nanometer scale, the measurement environment must be strictly controlled, which requires transfer of the mirror from the layer-removal apparatus to a measurement apparatus. For example, it is especially important to control the temperature of the mirror to be measured, wherein profile measurements must be performed at the same temperature before and after layer-removal processing. Hence, there is a need for an evaluation method by which the extent of layer-removal processing can be assessed *in situ* during actual layer-removal processing. Also, the evaluation method must provide data at the required accuracy, desirably not under the strict thermal-stability conditions required for interferometry.

Second, whenever reflective wave-front corrections are performed by local removal of one or more layers from the surface of a multilayer film, layer-removal processing desirably is performed while monitoring the degree of layer-removal. However, conventional layer-removal processing by polishing using a polishing liquid or by local irradiation using an ion beam in a vacuum chamber is performed under conditions incapable of providing thermal equilibrium conditions suitable for conventional measurements. Consequently, it conventionally is very difficult to provide quick feedback of, for example, interferometer measurements of the multilayer-film surface during layer-removal processing.

Third, conventional local layer-removal by IBM or CVM tends to damage the multilayer film in the region being processed due to layer-peeling. The multilayer film damaged in this manner in these locations tends to exhibit reduced reflectivity. Hence, there is a need for layer-removal methods that reduce collateral damage to the multilayer film, compared to conventional methods.

Fourth, in the Yamamoto technique as conventionally practiced, surface-profile corrections are performed with local removal of layer-pairs in discrete layer-pair units. Since actual corrections frequently are required that require removal of less than a discrete layer-pair unit, the conventional manner of surface-profile correction usually cannot achieve a surface correction of 0.2 nm or less. This is disadvantageous because surface corrections of 0.2 nm or less are required for achieving current target profile accuracies of 0.23 to 0.19 nm (RMS). Hence, there is a need for being able to achieve layer-removal at greater accuracies than obtainable by removing only discrete layer-pairs.

Fifth, in the Yamamoto technique as currently practiced, local removal of a layer-pair yields a discontinuous profile of layers in the multilayer film. *I.e.*, the remaining regions of the layer-pair surrounding the location where a portion of the layer-pair was removed presents abrupt layer edges. The abrupt edges produce corresponding discontinuities in the phase of reflected EUV light. The phase discontinuities cause local scattering of incident EUV light, which attenuates reflection of EUV light at that location, increases background noise, and degrades image quality.

Therefore, despite the benefits of the Yamamoto technique as currently practiced, further improvements are needed in order to achieve the current levels of image resolution and quality.

## Summary

The shortcomings of the prior art as summarized above are cured by the present invention that provides, *inter alia,* various embodiments of methods for manufacturing multilayer-film mirrors, as well as multilayer-film mirrors, EUV optical systems including one or more such mirrors, and EUV lithography (EUVL) apparatus including such optical systems.

According to a first aspect of the invention, a apparatus are provided for removing one or more surficial layers of a multilayer film on a multilayer-film mirror so as to correct a reflection wave-front produced by the multilayer-film mirror. The multilayer film comprises multiple alternating layers of at least a first layer-material and a second layer-material having mutually different refractive indices with respect to a prescribed wavelength. An embodiment of such an apparatus comprises a layer-removal device and an analysis device. The layer-removal device is situated and configured to remove at least a respective portion of one or more surficial layers of the multilayer film. The analysis device is situated and configured to analyze at least one of the removed layer-materials. This apparatus allows ascertainment of the amount of material removed from the surface of the multilayer film *in situ* as layer-removal is being performed. Furthermore, this apparatus allows such ascertainment to be performed without having to establish rigorous thermal stability of the mirror.

The layer-removal device desirably comprises an ion-beam-irradiation device situated and configured to direct a layer-ablating ion beam at a selected region of the surficial layer. Such a device is known as an ion-beam machining (IBM) device that utilizes the ion beam as an exemplary "layer-removal force." The ion beam removes material of a layer by ablation resulting from bombardment of the layer surface by the ions of the beam. Alternatively, the layer-removal device can be any of various other devices configured to direct a layer-removal force at the desired location on the surface of the multilayer film.

The analysis device desirably analyzes layer-material as the respective layer is being removed. This configuration allows the rate or extent of layer removal to be controlled in real time based upon data provided by the analysis device. An advantageous example of this analysis-device configuration is a mass analyzer such as a mass spectrometer. If the layer-removal device must be located in a vacuum environment, the mass analyzer can be situated in a vacuum chamber along with the layer-removal device, thereby readily allowing real-time monitoring (by the analysis device) of layer-removal. Alternatively, the analysis device can be configured to analyze the at least one layer-material after the respective layer has been removed.

Alternatively to a mass analyzer, the analysis device can be configured to measure a surface-distribution of the layer materials. Such an analysis device can be configured to detect, for example, a difference in reflectivity of the multilayer-film surface to infrared, visible, or ultraviolet light. To such end, the analysis device can include, for example, a CCD camera.

Another analysis device configured to measure a surface-distribution of the layer materials comprises at least one ellipsometer. In regions of the multilayer-film surface where layer-removal is not occurring, the topmost layer has a substantially uniform thickness. In contrast, the thickness (and typically also the material) of the top-most layer is not uniform in regions in which layer-removal is occurring or has occurred. By using an ellipsometer, a clear oscillating signal is obtained as layer-removal passes through each layer of the multilayer film, wherein the number of oscillations corresponds to the number of layers removed. Also, the distribution of layers exposed on the surface of the multilayer film as a result of layer-removal processing can be ascertained readily by ellipsometry, providing rapid feedback of data concerning the locations and extent of layer-removal processing that has occurred and that needs yet to be performed.

As yet another alternative, the analysis device can be a photoelectron spectrometer or Auger-electron spectrometer that detects electrons released from the surface of the multilayer film as the surface is being irradiated with, for example, an X-ray beam.

According to another aspect of the invention, methods are provided for removing one or more surficial layers of a multilayer film on a multilayer-film mirror so as to correct a reflection wave-front produced by the multilayer-film mirror. In an embodiment of such a method at least a respective portion of one or more surficial layers of the multilayer film is removed. At least one of the removed layer-materials is analyzed. As noted above, the layer-removal step desirably is performed by directing a layer-ablating ion beam at a selected region of the surficial layer, and the analyzing step desirably is performed as the respective layer is being removed (but can be performed after removal of the respective layer). For example, the layer-removal step can be performed by directing a layer-ablating ion beam, in a vacuum environment, at a selected region of the surficial layer, wherein the analyzing step is performed in real time on volatile products produced by ablation of the respective layer.

The invention also encompasses multilayer-film mirrors produced by such methods, EUV optical systems comprising one or more such multilayer-film mirrors, and EUVL apparatus including such an EUV optical system. In an EUVL apparatus, the multilayer-film mirror can be present as a component of, for example, an illumination-optical system and/or projection-optical system of the apparatus. Alternatively or in addition, the multilayer-film mirror can be configured as the reflective reticle that defines the pattern to be transfer-exposed using the apparatus.

According to yet another aspect of the invention, methods are provided for producing a multilayer-film mirror for use with a prescribed wavelength of incident light. An embodiment of such a method comprises the steps of forming a reflection surface on a mirror substrate, and forming a multilayer film on the reflection surface by forming a stacked laminate of multiple alternating layers of at least a first layer-material and a second layer-material at a prescribed period length suitable for rendering the reflection surface reflective to the incident light. The first and second layer-materials have mutually different refractive indices with respect to the prescribed wavelength. In a subsequent step, a profile of a reflected wave-front produced by reflection of the incident light from the multilayer film is measured. Based on the measured profile of the reflected wave-front, a layer-removal force is directed locally to the multilayer film so as to remove, at one or more specified locations on the multilayer film, at least a portion of a surficial layer of the multilayer film so as to reduce an aberration of the reflected wave-front. In another step, the respective layer-material removed from the specified location is detected, and, based upon the detected removal of layer-material, an amount of layer-material removed from the specified location is controlled to achieve a desired reduction of the wave aberration of the reflected light. As noted above, the step of directing a layer-removal force desirably comprises directing a layer-ablating ion beam, in a vacuum environment, at a selected region of the surface of the multilayer film. In such an instance, the detecting step desirably is performed in real time on volatile products produced by ablation of the respective layer.

According to yet another aspect of the invention, methods are provided for manufacturing a reflective optical system for use with a prescribed operating wavelength of light. An embodiment of such a method comprises multiple steps of which a first step involves forming a respective reflection surface on each of multiple mirror substrates. In a second step a respective multilayer film is formed on each reflection surface by forming a stacked laminate of multiple alternating layers of at least a first layer-material and a second layer-material at a prescribed period length suitable for rendering the respective reflection surface reflective to the incident wavelength. The first and second layer-materials have mutually different refractive indices with respect to the prescribed wavelength. Thus, respective multilayer-film mirrors are formed. A third step involves assembling the multilayer-film mirrors into a housing for the optical system. A fourth step involves measuring a wave aberration of the assembled optical system at the operating wavelength. This can be performed interferometrically. In a fifth step respective wave-front corrections to be made to the constituent multilayer-film mirrors in the optical system are computed from the measured wave aberration. In a sixth step, as required according to the computed respective wave-front corrections, one or more layers are removed selectively from the multilayer-film surface of the respective multilayer-film mirrors so as to correct a reflective-surface profile of the multilayer-film mirror in a manner corresponding to the required respective wave-front correction. The fifth, sixth, third, and fourth steps (in that order) are repeated as required until the wave aberration of the optical system does not exceed a predetermined specification.

In the fifth step, the correction to be made to the optical system includes respective corrections to be made to the individual reflective-surface profiles of the constituent multilayer-film mirrors. Note that "reflective-surface profile" does not refer to the actual physical configuration of the mirror surface but rather to the profile of the effective reflective surface collectively defined by the layers of the multilayer film. The sixth step can be performed using *in situ* monitoring as summarized above. In this regard, Equations (3)-(5) can be used to determine the respective numbers of layers to remove at respective locations on respective mirrors in the sixth step.

The method summarized above can include the step, between the first and second steps, of configuring each mirror substrate to have a respective desired external-shape profile. This step of configuring the external-shape profiles of the mirror substrates typically comprises forming at least one hole (aperture) or cutout in at least one of the mirror substrates of the mirrors of the system. Holes and/or cutouts are provided as required to give the respective mirrors respective shapes allowing light to propagate through the subject optical system without being shaded or blocked. Normally, machining cutouts and holes in a mirror substrate before forming the reflection surface renders the mirror substrate subject to "edge wear," or edge deformation, during subsequent grinding and polishing of the reflection surface. By machining the cutouts and holes after machining the reflection surface, edge wear is prevented. Residual stress imparted by machining the cutouts and holes is corrected during the fifth and sixth steps of the method.

In the second step each multilayer film is formed having a respective number of "layer-sets", wherein each layer-set comprises a respective layer of the first layer-material and a respective layer of the second layer-material. (*E.g.*, if the multilayer film is formed only of an alternating stack of two different layers, then each "layer-set" can be regarded as a "layer-pair." Each layer-set has a thickness substantially equal to the period length of the multilayer film. In the second step the respective number of layer-sets is greater than a minimum number of layer-sets required to obtain a prescribed reflectivity from the respective multilayer film plus a maximum number of layer-sets that would need to be removed from the respective multilayer film to achieve a respective desired wave-front correction. Thus, after correction performed in the fifth and sixth steps, the mirror still exhibits maximal reflectivity because it still has at least the minimum number of layer-sets in the multilayer film for maximal reflectivity.

In the fourth step the wave aberration desirably is measured at a plurality of wavelengths including the operating wavelength. In other words, the plural wavelengths represent the normal operating range of wavelengths with which the optical system is intended for use. This results in better correction.

The fifth step can comprise computing a sum, within an incrementally divided pupil plane of the optical system, of an evaluation function, and computing correction amounts by an optimization routine resulting in minimization of the evaluation function. The evaluation function can include differences between a change in optical-path length resulting from correction of the optical system and a corresponding displacement of the measured wave-front from an aberration-free wave-front. The change in optical-path length obtained in this situation is a function of parameters for correcting the optical system. Thus respective measured amount of dislocation exhibited by each mirror with respect to an aberration-free wave-front is compensated for by changing the optical path lengths for each of the rays obtained by incrementally dividing the pupil plane, wherein the parameters are determined by least squares. *I.e.*, the difference between (a) the change in optical-path length obtained by correcting the optical system with respect to rays passing through the respective regions of the pupil and undergoing image formation at a single point on the image plane and (b) the dislocation with respect to an aberration-free wave-front is obtained. The squares of these differences are determined and summed, and the optical-system parameters are corrected so as to minimize the sum. Thus, the optical system is corrected while taking into account rays passing through all locations of the pupil plane.

The corrections calculated in the fourth step can include only parameters relating to respective reflective-surface profiles of the multilayer films of the multilayer-film mirrors. This is effective when adjustments are made also to parameters such as relative positions of the mirrors in the optical system as well as the reflective-surface profiles of the constituent mirrors. Alternatively, the corrections calculated in the fourth step can be limited to parameters relating to respective reflective-surface profiles of the multilayer films of the multilayer-film mirrors. The parameters relating to the respective reflective-surface profiles can be expressed by respective systems of orthogonal functions, such as Zernike polynomials. Thus, complex corrections with non-rotational symmetry can be calculated. The degrees of the polynomials can be selected according to the target accuracy desired, thereby simplifying the calculations.

The fifth step can comprise computing correction amounts by an optimization routine resulting in minimization of an evaluation function. The optimization routine can include imposing a limitation that, in the sixth step, changes in respective reflective-surface profiles of the respective multilayer films are made only by locally removing layers in period-length increments from the multilayer film.

In the sixth step, while selectively removing one or more layers from the multilayer-film surface of the respective multilayer-film mirrors, an in-plane distribution of layers can be observed while being removed. These observations can be made by producing images of the multilayer-film surfaces using visible light or infrared light at a wavelength of 400 nm or more. This wavelength range is especially useful for observing differences in reflectivity of Mo and Si (which are the most commonly used materials for fabricating multilayer films in mirrors used for EUV radiation).

Further with respect to the sixth step, while selectively removing one or more layers from the multilayer-film surface of the respective multilayer-film mirrors, an *in situ* monitoring of the removal can be performed in real time. Data produced by the monitoring can be used to ensure respective desired amounts of material are removed at the respective desired locations on the multilayer-film surfaces.

According to yet another aspect of the invention, multilayer-film mirrors are provided that comprise a mirror substrate defining a reflection surface, and a multilayer film formed on the reflection surface. The multilayer film defines an effective region intended to be a region from which light of a desired wavelength is reflected from the multilayer-film mirror. The mirror also includes at least one coordinate-reference mark situated outside the effective region. The reflection surface can be (and typically is) aspheric. Desirably, multiple coordinate-reference marks are included, which are useful as reference points used during various processing steps in the manufacture of the mirrors and assembly of the mirrors into the optical system. By placing the marks outside the effective region, the optical performance of the effective region.

In another embodiment of a method for manufacturing a multilayer-film mirror, a first multilayer film is formed on a surface of a mirror substrate. The first multilayer film has a prescribed period length and is formed by laminating multiple layer-sets each comprising respective alternating layers of at least two types of substances having mutually different refractive indices for a wavelength of light with which the mirror is to be used. A profile of a reflected wave-front produced by reflection of the light from a surface of the first multilayer film is obtained. From the profile is identified a wave aberration requiring reduction. Based on the obtained profile, at least one layer-set of a second multilayer film is laminated to selected regions of the surface of the first multilayer film so as to correct the wave aberration. The period length of the second multilayer film desirably has a period length substantially equal to the period length of the first multilayer film. Correcting the reflective-surface profile of the mirror in this manner avoids having to disrupt the first multilayer film when making the correction(s).

The step of laminating the second multilayer film can be performed by situating a mask between the first multilayer film and a source of the second multilayer film. The mask defines at least one aperture corresponding to a selected region on the first multilayer film at which the at least one layer-set of the second multilayer film is to be laminated. Using the mask as a guide, the at least one layer set of the second multilayer film is laminated on the surface of the first multilayer film. The mask can be configured so that the mask can be moved during formation of the second multilayer film. An exemplary mask movement is rotation. Alternatively, the second multilayer film can be laminated at the selected regions by photo-CVD, which can be performed without a mask.

Further alternatively, the second multilayer film can be formed by first forming a resist layer on the surface of the first multilayer film, wherein the resist is patterned so as to define at least a portion of a selected region on the first multilayer film at which the at least one layer-set of the second multilayer film is to be laminated. Using the patterned resist layer as a mask, the at least one layer set of the second multilayer film is laminated on the surface of the first multilayer film.

Formation of the second multilayer film can be performed under conditions in which the lamination is monitored *in situ* using, for example, a technique as summarized earlier above. Based on data produced by the *in situ* monitoring, further lamination of the second multilayer film can be halted when a desired lamination amount is reached.

In yet another embodiment of a method for manufacturing a multilayer-film mirror, a first multilayer film is formed on a surface of a mirror substrate as summarized above. A profile of a reflected wave-front produced by reflection of the light from a surface of the first multilayer film is obtained. From the profile a wave aberration requiring reduction is identified. Based on the obtained profile, at least one layer-set is removed from selected locations of the surface of the first multilayer film. At least one layer-set of a second multilayer film is laminated to selected regions of the surface of the first multilayer film, so as to correct the wave aberration.

Again, the second multilayer film can have a period length substantially equal to the period length of the first multilayer film. Also, during lamination of the second multilayer film at the selected locations, *in situ* monitoring of the lamination can be performed. Based on data produced by the *in situ* monitoring, further lamination of the second multilayer film can be halted when the *in situ* monitoring has revealed that a desired lamination amount is reached. Similarly, the removal of the at least one layer-set from the first multilayer film can be monitored *in situ,* wherein, based on data produced by the *in situ* monitoring, further removal of the first multilayer film can be halted when the *in situ* monitoring has revealed that a desired amount thereof has been removed.

Yet another embodiment of a multilayer-film mirror comprises, on a mirror substrate, a first multilayer film formed on the reflective surface. The first multilayer film has a prescribed period length and is formed by laminating multiple layer-sets each comprising respective alternating layers of at least two types of substances having mutually different refractive indices for a wavelength of light with which the mirror is to be used. The first multilayer film has a surface defining at least one location at which a respective portion of at least a topmost layer-set has been removed to reduce a wave aberration of light reflected from the multilayer-film mirror. A second multilayer film is laminated to at least one selected location on the surface of the first multilayer film, wherein the second multilayer film has a period length substantially equal to the period length of the first multilayer film to correct the reflected wave-front produced by the multilayer-film mirror. The second multilayer film desirably is laminated to at least one location on the first multilayer film at which a respective portion of at least a topmost layer-set has been removed.

In yet another embodiment of a method for manufacturing a multilayer-film mirror, a multilayer film (as described above) is formed on a surface of a mirror substrate. The multilayer film comprises multiple layer-sets each comprising respective alternating layers of at least a first substance and a second substance. The first substance exhibits a relatively large difference in respective refractive index to EUV light relative to the refractive index of a vacuum, and the second substance exhibits a relatively small difference in relative refractive index to EUV light relative to the refractive index of a vacuum. A profile of a reflected wave-front produced by reflection of the light from a surface of the multilayer film is obtained. From the profile is identified a wave aberration requiring reduction. Based on the obtained profile, at least one layer-set is removed from at least one selected location on the surface of the multilayer film, so as to leave exposed at the selected location a next layer of the second material. To the exposed layer of the second material at the selected location is laminated an amount of the first material to a prescribed thickness that is less than a layer thickness of the first material in the multilayer film, so as to reduce the wave aberration. By thus "adding back" a layer of the first material at a thickness less than the usual layer thickness, the wave aberration of the mirror can be corrected substantially more accurately than other methods in which layer addition or removal is in units of usual layer thickness or usual layer-set thickness.

In yet another embodiment of a method for manufacturing a multilayer-film mirror, a multilayer film is formed on a surface of a mirror substrate, as described above. The multilayer film is formed by laminating multiple layer-sets each comprising respective alternating layers of at least a first substance and a second substance. The first substance exhibits a relatively large difference in respective refractive index to EUV light relative to the refractive index of a vacuum, and the second substance exhibits a relatively small difference in relative refractive index to EUV light relative to the refractive index of a vacuum. A profile of a reflected wave-front produced by reflection of the light from a surface of the multilayer film is obtained. From the profile, a wave aberration requiring reduction is identified. Based on the obtained profile, at corresponding locations on a surface of the multilayer film, at least one layer-set of the multilayer film is removed selectively in a manner yielding a smoothly connected corrected reflection wave-front. Thus, curvature of the reflection wave-front relative to the incidence wave-front is restricted.

Desirably, in the corresponding locations, each layer of the first material that is removed is provided with respective edges having a relatively steep inclination, and each layer of the second material that is removed is provided with respective edges having a relatively gentle inclination.

In the corresponding locations, each layer of the first material that is removed desirably is removed at a first removal rate, and each layer of the second material that is removed is removed at a second removal rate. A ratio of the first and second removal rates desirably is equal to a ratio of an inverse of a difference between vacuum refractive indices of the respective materials and refractive indices of the materials. As a result of these conditions, the corrected reflection wave-front produced by a boundary of adjacent layers of the first and second materials is connected smoothly.

The foregoing and additional features and advantages of the invention will be more readily apparent from the following detailed description, which proceeds with reference to the accompanying drawings.

## Brief Description of the Drawings

FIG. 1 is a schematic transverse section showing removal of a portion of a multilayer film while monitoring the removal using a mass analyzer, according to a first representative embodiment.

FIG. 2(a) is a schematic plan view of a multilayer film on the surface of a multilayer-film mirror subjected to layer-removal processing according to any of the first, second, third, and fourth representative embodiments, showing an exemplary distribution of molybdenum (Mo) and silicon (Si) exposed on the surface.

FIG. 2(b) is an elevational section along the line 2b-2b in FIG. 2(a).

FIG. 3 is a schematic transverse section showing removal of a portion of a multilayer film while monitoring the removal using an X-ray illumination device and photoelectron detector, according to a second representative embodiment.

FIG. 4 is a schematic transverse section showing removal of a portion of a multilayer film while monitoring the removal using ellipsometers, according to a third representative embodiment.

FIG. 5 is a schematic transverse section showing removal of a portion of a multilayer film while monitoring the removal using a CCD camera, according to a fourth representative embodiment.

FIG. 6 is a schematic optical diagram of an EUV lithography (EUVL) apparatus, according to the fifth representative embodiment, comprising corrected multilayer-film mirrors produced according to, e.g., any of the first, second, third, and fourth representative embodiments.

FIG. 7 is a block diagram of a process for manufacturing an optical system including at least one multilayer-film mirror, according to the sixth representative embodiment.

FIG. 8 includes plots of projection-system transmissivity versus wavelength and wave aberration versus pupil coordinate, illustrating a method of measuring wave aberration at a plurality of wavelengths, as described in the sixth representative embodiment.

FIG. 9 is a plot of the respective surface-reflectivity spectra of Mo and Si, as discussed in the sixth representative embodiment.

FIG. 10 is a block diagram of a process for manufacturing an optical system including at least one multilayer-film mirror, wherein the process includes a step involving processing the external shape of the mirror substrate of the multilayer-film mirror, as discussed in the sixth representative embodiment.

FIG. 11 is a schematic optical diagram of a projection-optical system, comprising four aspheric multilayer-film mirrors, for an EUVL apparatus, according to a first example described in the sixth representative embodiment.

FIG. 12 shows the respective external shapes of each of the four aspheric multilayer-film mirrors in the projection-optical system depicted in FIG. 11.

FIG. 13 is a schematic optical diagram of an EUVL apparatus including the projection-optical system of FIG. 11.

FIGS. 14(a) and 14(b) are respective schematic elevational sections of a multilayer-film mirror, illustrating respective steps of a method, according to the seventh representative embodiment, for adding at least one layer-set to the multilayer film of the mirror so as to correct the wave aberration of the mirror.

FIG. 15(a) is a schematic plan view (middle) and elevational section (bottom) of a multilayer-film mirror before adding a layer-set according to the seventh representative embodiment.

FIGS. 15(b)-15(c) are schematic plan views (middle) and elevational sections (bottom) showing the results of two respective steps in an exemplary process for adding layer-sets as described in the seventh representative embodiment. These figures also show (top) respective masks used for guiding the formation of the additional layer-sets.

FIG. 16(a) is a schematic elevational section of a multilayer-film mirror corrected using a variation of the seventh representative embodiment, in which a first additional layer-set was formed at a selected location on the top layer-set of the multilayer film, followed by addition of two further additional layer-sets to the first additional layer-set.

FIG. 16(b) is a schematic elevational section showing steps in another variation of the method according to the seventh representative embodiment, wherein portions of the top layer-set of the multilayer film were removed, followed by addition of two layer-sets to the remaining portion of the top layer-set.

FIG. 17 is a schematic elevational section of a multilayer-film mirror corrected by selected removal of layer-sets, as described in the eighth representative embodiment.

FIG. 18 is a schematic elevational section of a multilayer-film mirror corrected by selective removal of layers from the multilayer film, as described in the ninth representative embodiment. Also shown are incident and reflected wave-fronts produced by the mirror.

FIG. 19 is a flow chart of steps in a process for manufacturing a microelectronic device, the process including use of an EUVL apparatus (including multilayer-film mirrors) for performing microlithography, as described in the tenth representative embodiment.

FIG. 20 is a flow chart of certain steps in the microlithography step in the process shown in FIG. 19.

FIGS. 21(a) and 21(b) are respective schematic elevational sections diagramming the principles of correction of a reflected wave-front by removing a layer-pair from the multilayer film, according to conventional methods.

**Detailed Description**

The invention is described below in the context of representative embodiments that are not intended to be limiting in any way.

**First Representative Embodiment**

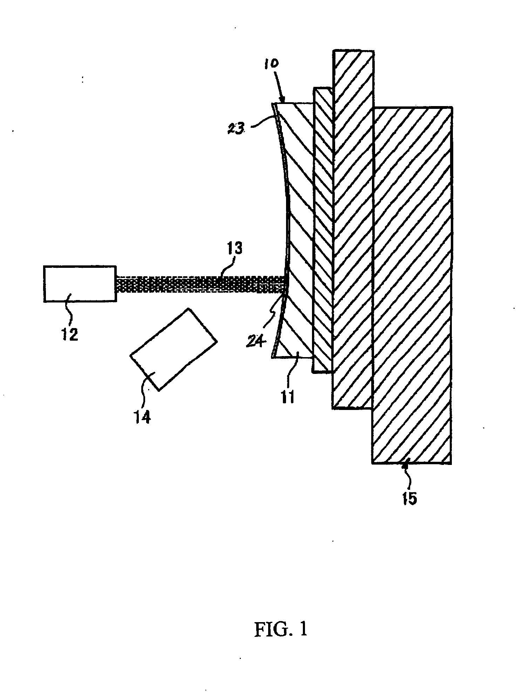

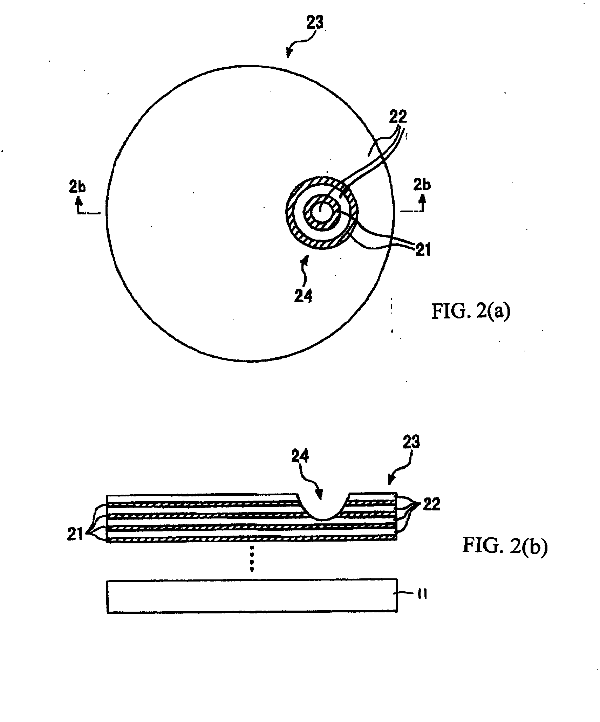

An apparatus, according to this embodiment, for selectively removing one or more surficial layers of a multilayer film from a selected location on a multilayer-film mirror 10 is depicted schematically in FIG. 1. Also, FIGS. 2(a)-2(b) depict a plan view and elevational section of a multilayer film 23 subjected to selected localized layer-removal using the apparatus of FIG. 1. By way of example, the subject multilayer film 23 comprises multiple alternating layers of molybdenum (Mo) 21 and silicon (Si) 22 formed on the reflection surface of a mirror substrate 11. The surface of the multilayer film 23 defines the reflective-surface profile of the multilayer-film mirror 10. FIG. 2(a) depicts an exemplary configuration of several Mo and Si layers exposed at the surface after processing, and FIG. 2(b) is a section along the line 2b-2b in FIG. 2(a).

Selective layer-removal by the apparatus shown in FIG. 1 is performed in a suitable vacuum chamber (not shown). For layer-removal processing the multilayer-film mirror 10 is mounted to a stage 15. In the figure the mirror 10 has a concave surface, on which the multilayer film 23 faces to the left in the figure. A representative portion of the multilayer film 23 is shown in FIGS. 2(a)-2(b). In the multilayer film 23 layers of Mo 21 and Si 22 are laminated alternatingly, wherein the uppermost layer is a Si layer 22.

Removal of one or more layers of the multilayer film 23 at a selected location on the mirror surface is performed in general by directing a "layer-removal force" onto the selected location. In this embodiment, the layer-removal force is an ion beam 13 produced by and propagating from an ion source 12. Meanwhile, in this embodiment, a mass analyzer 14 (*e.g.,* mass spectrometer) is situated relative to the multilayer film 23 for analyzing substances released from the multilayer film due to irradiation by the ion beam 13. The mass analyzer 14 desirably is situated inside the vacuum chamber and is configured for analyzing the respective masses of volatile substances released by the ion-beam irradiation.

The method for selectively removing one or more layers of the multilayer film 23, using the apparatus of FIG. 1, is as follows. The multilayer-film mirror 10 shown in FIG. 1 is one of plural multilayer-film mirrors of an image-formation optical system (projection-optical system) of an EUVL apparatus. After forming the multilayer film 23 on the surface of the mirror substrate 11, the multilayer-film mirror 10 is assembled into the lens column (housing) of the projection-optical system and adjusted as required. The wave aberration for the entire projection-optical system is measured using an interferometer utilizing a measurement wavelength of 13.5 nm (*i.e.* the wavelength with which the optical system normally will be used). Based on the measurement data, a calculation is made to determine the correction to be made to the reflection wave-front produced by the multilayer-film mirror 10 to reduce the wave aberration of the optical system. The calculated correction to the mirror includes data regarding the locations on the mirror surface at which a respective correction should be made by layer-"shaving," as well as the respective numbers of layers to be removed at the location(s). The mirror 10 normally is removed from the column for making the correction.

For example, assume that reflection wave-front measurements reveal the necessity to remove two Mo layers 21 from a selected location 24 on the multilayer film 23 to yield a desired improvement in wave aberration. The subject mirror 10 is mounted on the stage 15, which controllably positions the mirror 10 for irradiation by the ion beam 13 at the location 24. As the ion beam 13 irradiates the selected location 24, substances forming the multilayer film 23 in the location are ablated, and the ablation products are detected by the mass analyzer 14.

The ion-beam irradiation first ablates the uppermost Si layer 22 and proceeds layer-by-layer depthwise, as shown in FIGS. 2(a) and 2(b). The ablated Si is detected by the mass analyzer 14. As ablation penetrates through the uppermost Si layer 22, the underlying Mo layer 21 becomes exposed to the ion beam 13, resulting in ablation of Mo that is detected by the mass analyzer 14. As ablation continues further depthwise into the multilayer film 23, Si and Mo are detected alternatingly by the mass analyzer 14.

As shown in FIG. 2(b), as ablation proceeds through the uppermost Si layer 22 into underlying layers, edges of one or more previously ablated layers are exposed at the irradiation site. These exposed edges result, with further irradiation, in the release of both Si and Mo that are detected by the mass analyzer 14. This does not present a detection problem because the detection signal for Si or Mo is greater whenever the ion beam is ablating a Si layer 22 or Mo layer 21, respectively, regardless of whether the edges of previously ablated layers are exposed at the irradiation site. Thus, as ablation continues depthwise through successive layers, the intensity of the mass-analyzer signal for Mo and Si changes in a mutually alternating manner. Also, with further ablation especially through many layers, the contrast of the Mo and Si "peaks" in the mass-analyzer signal gradually decreases.

For a multilayer-film mirror intended for use in an EUVL apparatus, ascertaining the number of Mo layers 21 that have been ablated is important. As ablation proceeds through the uppermost Si layer 22, a high-amplitude Si signal is produced by the mass analyzer 14. This Si signal has a higher amplitude than the signal that would be produced by any of the other Si layers 22 in the multilayer film 23. As ablation proceeds to the uppermost Mo layer 21, a high-amplitude Mo signal is produced, which has a higher amplitude than the signal that would be produced by any of the other Mo layers 21 in the multilayer film 23, and is produced immediately after the highest-amplitude Si signal is produced. (Note that the rate of depthwise ablation is greatest in the center of the irradiated region 24.) Then, as ablation enters the penultimate Si layer 22 and then the penultimate Mo layer 21, the respective signals produced by the mass analyzer can be distinguished readily from the respective signals produced by the uppermost Si and Mo layers. This allows ablation to be stopped reliably at the desired depth in the multilayer film 23.

Since the mass analyzer 14 is situated within the vacuum chamber housing the multilayer-film-removal apparatus, the mass analyzer 14 produces processing feed-back data as ablation progresses. In other words, layer-removal is monitored in real time, which allows layer-removal processing to be stopped or otherwise controlled immediately when the prescribed number of Mo layers has been removed. Thus, high-accuracy and high-precision wave-front correction is achieved. In addition, this embodiment eliminates any need for the mirror substrate to reach thermal equilibrium before conducting wave-front measurements during layer-removal (which is a key disadvantage of measuring wave-fronts in a conventional manner using an interferometer). Hence, this embodiment performs corrective processing more quickly and accurately than conventionally.

Second Representative Embodiment

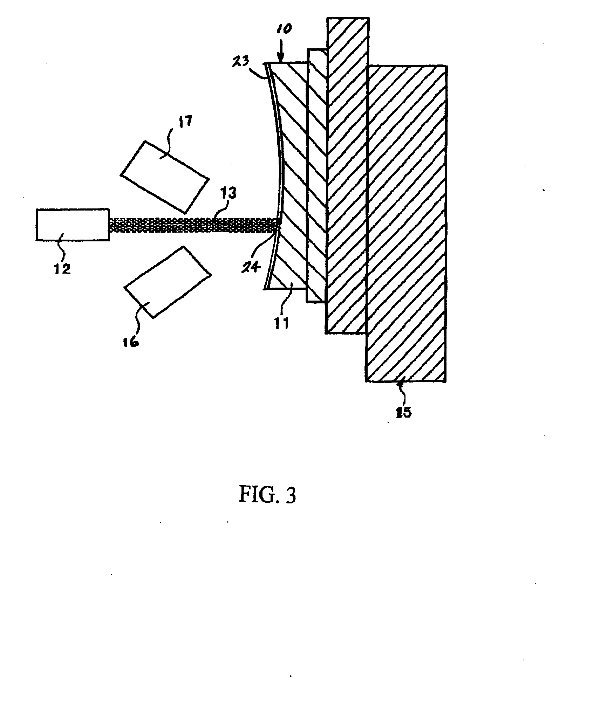

An apparatus, according to this embodiment, for locally removing one or more surficial layers of a multilayer film is shown in FIG. 3, in which components that are similar to respective components of the first representative embodiment have the same respective reference numerals and are not described further.

The apparatus of FIG. 3 comprises an X-ray illumination device 16 that produces a monochromatic X-ray beam. The apparatus also includes a photoelectron detector 17. The X-ray illumination device 16 and photoelectron detector 17 are situated and configured to determine whether the layer exposed on the surface of the multilayer film 23 at the ion-beam irradiation site 24 during or after processing is Mo or Si. To such end, the X-ray illumination device 16 directs a monochromatic X-ray beam onto the surface of the multilayer film 23. The material at the site of impingement of the X-ray beam is determined by the photoelectron detector 17, which analyzes photoelectrons produced at the site by the X-ray irradiation. Thus, a two-dimensional map of the ion-beam irradiation site 24 is obtained. The map contains data indicating the corresponding two-dimensional distribution of materials exposed at the surface of the multilayer film 23 at the ion-beam irradiation site 24 (see FIG. 2(a)). Thus, as in the first representative embodiment, it is possible to ascertain the particular layer to which layer-removal processing has progressed.

If the ion-beam irradiation site 24 does not have the simple shape shown in FIGS. 2(a)-2(b), the photoelectron-distribution data produced by the photoelectron detector 17 may not allow a determination of whether the irradiation site 24 is concave or convex relative to adjoining regions. However, if layer-removal processing is performed while controlling the position and time duration of ion-beam irradiation, according to this embodiment, determining the layer to which ablation has progressed is readily performed. Also, this determination readily is made for other regions of the surface of the multilayer film 23 that are processed.

As successive layers of the multilayer film 23 are removed using the apparatus of FIG. 3, each newly exposed layer is analyzed. Hence, this apparatus allows continuous analysis of layer-removal as layer-removal is progressing. Also, since the X-ray illumination device 16 and photoelectron detector 17 are situated within the vacuum chamber (not shown) housing the multilayer-film-removal apparatus, the processing feed-back data can be produced as layer-ablation progresses. In other words, layer-removal is monitored in real time, which allows processing to be stopped or otherwise controlled immediately when the prescribed number of, e.g., Mo layers 21 has been removed. Thus, high-accuracy and high-precision wave-front correction is achieved. In addition, this embodiment eliminates any need for the mirror substrate 11 to reach thermal equilibrium before conducting wave-front measurements during layer-removal (which is a key disadvantage of measuring wave-fronts in a conventional manner using an interferometer). Hence, this embodiment performs corrective processing more quickly and accurately than conventionally.

In the configuration shown in FIG. 3, determinations of whether the uppermost exposed layer in the multilayer film at the ablation site is Mo or Si is determined based on photoelectron spectroscopy. But, this embodiment is not limited to photoelectron spectroscopy. It alternatively is possible to make this determination using, *e.g.*, an Auger electron spectroscopy device.

Third Representative Embodiment

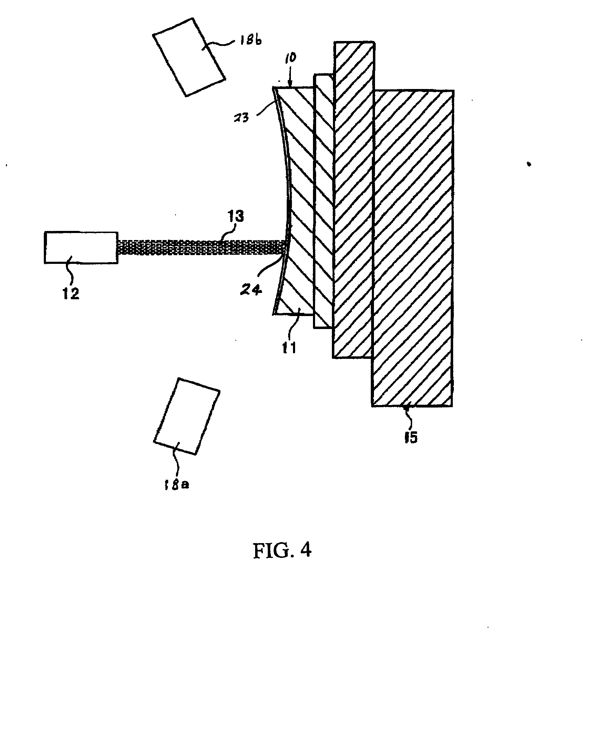

An apparatus, according to this embodiment, for locally removing one or more surficial layers of a multilayer film is shown in FIG. 4, in which components that are similar to respective components of the first representative embodiment have the same respective reference numerals and are not described further.

The apparatus of FIG. 4 comprises multiple ellipsometers 18a, 18b that evaluate the region of the multilayer-film surface 23 being processed by the ion beam 13. The ellipsometers 18a, 18b measure the status of the exposed layer on the surface by irradiating a collimated beam of monochromatic or quasi-monochromatic light, which is polarized in a known state, at the exposed layer and measuring the polarization status of the reflected light. The light can be monochromatic laser light or light from a polychromatic light source made monochromatic by passage through a prism, diffraction grating, or analogous device. For irradiation onto the exposed layer, the light typically is deflected by an optical element or the like (not shown). The light reflected by the exposed layer exhibits changes in polarization according to the refractive index, thickness, and structure of the irradiated exposed layer. Ellipsometric measurements allow changes in structure and composition of the layer in the vicinity of the ion-beam irradiated surface to be measured with good sensitivity. Upon completing removal of each "layer-set" (in this instance a "layer-pair" consisting of one respective Si layer 22 and one respective Mo layer 21), the structure of the exposed region of the multilayer film 23 is returned to the same status as before commencing removal. Hence, as processing continues through multiple layer-sets, the signal obtained by the ellipsometers 18a, 18b repeatedly "oscillates" in a corresponding manner. By measuring the number of these "oscillations," the number of layer-sets actually removed by the ion beam 13 is determined readily as processing progresses.

Determinations of layer-removal using the apparatus of FIG. 4 can be performed after layer-removal processing has been performed at one or more selected locations 24 on the multilayer-film surface. Alternatively or in addition, local layer-removal can be monitored in real time as layer-removal progresses. In other words, layer-removal can be monitored in real time, which allows removal-processing to be stopped or otherwise controlled immediately when the prescribed number of, e.g., Mo layers 21 has been removed. Thus, high-accuracy and high-precision wave-front correction is achieved. In addition, this embodiment eliminates any need for the mirror substrate 11 to reach thermal equilibrium before conducting wave-front measurements during layer-removal (which is a key disadvantage of measuring wave-fronts in a conventional manner using an interferometer). Hence, this embodiment performs corrective processing more quickly and accurately than conventionally.

Fourth Representative Embodiment

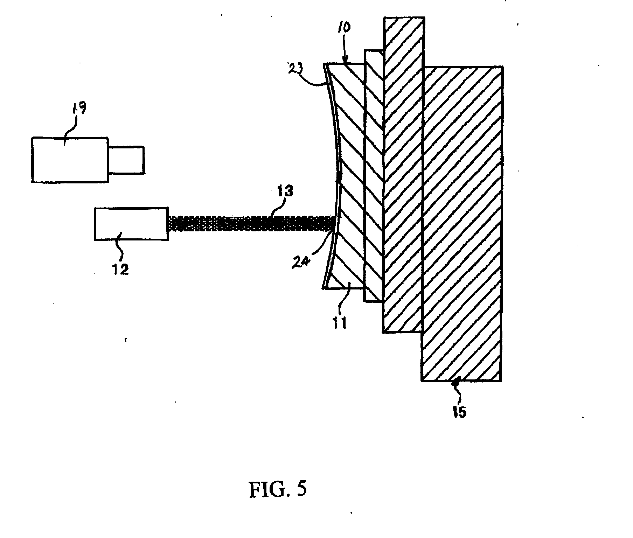

An apparatus, according to this embodiment, for locally removing one or more surficial layers of a multilayer film 23 is shown in FIG. 5, in which components that are similar to respective components of the first representative embodiment have the same respective reference numerals and are not described further.

The apparatus of FIG. 5 employs a CCD camera 19, situated within the vacuum chamber (not shown) in which layer-removal is being performed, oriented and configured for picking up an image of the irradiated location 24 on the surface of the multilayer film 23. During local layer-removal at the selected region 24 on the surface of a Mo/Si multilayer film, for example, respective loci are produced where Si is exposed and where Mo is exposed as the uppermost layer. But, Si and Mo layers exhibit respectively different reflectivity characteristics with respect to incident infrared, visible, and ultraviolet light. For example, with respect to visible light, an exposed Mo layer 21 exhibits higher reflectivity than an exposed Si layer 22, and this difference is clearly discernible. These differences are readily detectable by the CCD camera 19. Thus, the identity of a layer exposed by ion-beam ablation can be determined readily. Also, the relative amounts of material removed from the surface of the multilayer film 23 at various respective locations can be ascertained by producing a map of the substance distribution over the surface of the multilayer film 23.

Because the CCD camera 19 is situated inside the vacuum chamber in which layer-removal is being performed, monitoring of layer-removal can be performed as layer-removal is progressing. In other words, layer-removal is monitored in real time, which allows layer-removal processing to be stopped or otherwise controlled immediately when the prescribed number of, *e.g.*, Mo layers 21 has been removed. Thus, high-accuracy and high-precision wave-front correction is achieved. In addition, this embodiment eliminates any need for the mirror substrate 11 to reach thermal equilibrium before conducting wave-front measurements during layer-removal (which is a key disadvantage of measuring wave-fronts in a conventional manner using an interferometer). Hence, this embodiment performs corrective processing more quickly and accurately than conventionally.

The embodiment shown in FIG. 5 performs local layer-ablation using an irradiating ion beam 13. But, this configuration is not limiting. It alternatively is possible to use another layer-removal method, such as local "polishing" of the multilayer-film surface using a polishing fluid applied using a small-tool polishing pad. In this alternative configuration, layer-removal can be performed in an ambient atmosphere rather than in a vacuum environment. Processing in an ambient atmosphere is very convenient for use of the CCD camera 19.

Also, in the embodiment of FIG. 5, a visible image of the surface of the multilayer film is picked up by the CCD camera 19, which produces an image of the distribution of substances over the surface of the multilayer film 23. However, since the substance distribution is detected using differences in reflectivity with respect to infrared, visible, and ultraviolet light, it also is possible to produce an image of the substance distribution by a means other than a CCD camera 19.

Fifth Representative Embodiment

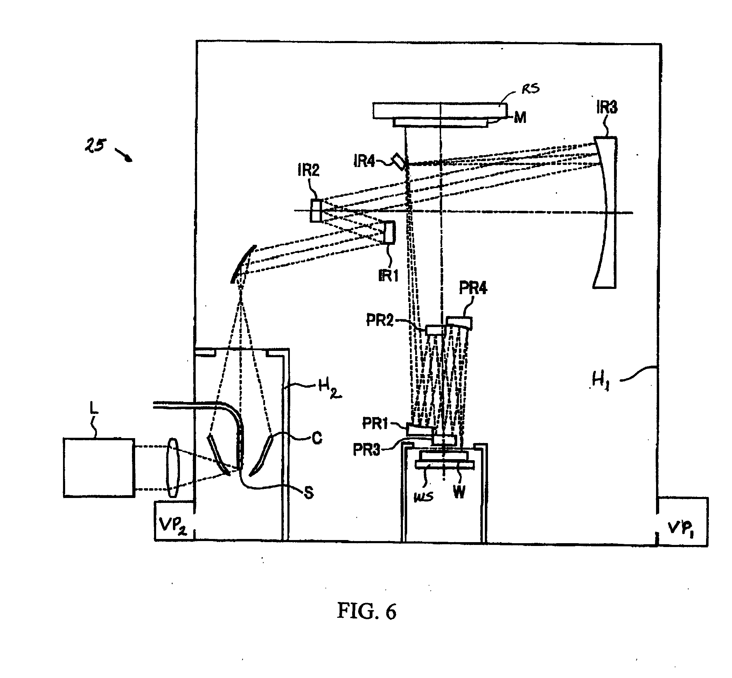

FIG. 6 depicts an EUVL apparatus 25 comprising at least one multilayer-film mirror corrected using any of the first, second, third, and fourth representative embodiments. The EUVL apparatus 25 comprises an EUV light source S, a condenser C, an illumination-optical system (comprising mirrors IR1, IR2, IR3, IR4), a reticle stage RS (for holding a reflective reticle M), a projection-optical system (comprising mirrors PR1, PR2, PR3, PR4), and a wafer stage WS (for holding a wafer W). The depicted EUV light source S is a laser-plasma-light source comprising a plasma-excitation laser L. Alternatively, the EUV light source S can be a discharge-plasma light source or a radiation source such as a SOR (synchrotron orbit radiation) source. The EUV light source S (and any optical components thereof such as the mirror C) are contained in a vacuum chamber $H_2$ evacuated by a respective vacuum pump $VP_2$. The mirrors IR1, IR2, IR3, IR4 of the illumination-optical system typically include one or more grazing-incidence mirrors that reflect EUV radiation incident thereto at high angles of incidence, at least one multilayer-film mirror, and a filter that transmits only EUV radiation of a prescribed wavelength. Thus, the illumination-optical system illuminates the reticle M with EUV radiation of the desired wavelength.

Since no transparent substances exist in the EUV wavelength range, the reticle M is a reflective-type reticle. So as to be reflective to EUV radiation, the reticle M has a surficial multilayer film similar to the multilayer film formed on a mirror substrate, as described above. Hence, the reticle M can be corrected, in the same manner as a multilayer-film mirror used in the illumination-optical and/or projection-optical systems, using an apparatus according to any of the first, second, third, and fourth representative embodiments.

The mirrors PR1, PR2, PR3, PR4 of the projection-optical system (image-formation optical system) are multilayer-film mirrors. The projection-optical system forms an image on the wafer W of the circuit pattern defined on the reticle M. So as to be imprintable with the image, the upstream-facing surface of the wafer W is coated with a suitable resist. Because EUV radiation is absorbed and attenuated in the atmosphere, the illumination-optical system and projection-optical system are maintained at prescribed vacuum levels (*e.g.*, $1 \times 10^{-5}$ Torr or less). To such end, the illumination-optical system and projection-optical system are contained in a vacuum chamber $H_1$ evacuated by a vacuum pump $VP_1$.

This embodiment is not limited to the configuration shown in FIG. 6. Certain modifications can be made. For example, the depicted apparatus need not be used for EUVL. It is possible to use multilayer-film mirrors, produced and corrected as described herein, in any of various systems other than EUVL systems, and for wavelengths other than EUV wavelengths.

Sixth Representative Embodiment

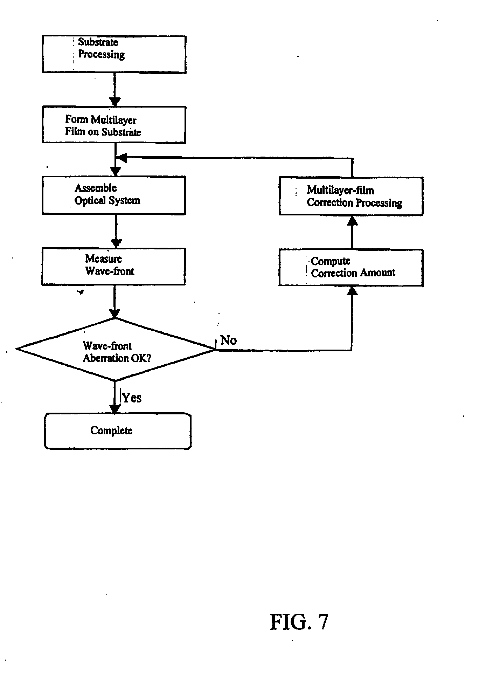

This embodiment is directed to a process for manufacturing an optical system that includes at least one multilayer-film mirror, and is depicted in FIG. 7. In a first step ("Substrate Processing") of the method, a mirror substrate is subjected to processing as required to produce a substrate having a prescribed reflective-surface profile (curvature or other surficial profile), surface roughness, and the like. For example, if the multilayer-film mirror is to be used in a projection-optical system of an EUVL apparatus, the surface of the mirror substrate typically is provided with an aspherical concave profile. The number of mirror substrates processed in this step corresponds to the number of multilayer-film mirrors required in the subject optical system. For example, in EUVL projection-optical systems, the number of multilayer-film mirrors is 4, 6, or 8.

In the second step ("Form Multilayer Film on Substrate") respective multilayer films are formed on the mirror substrates. By way of example, the multilayer film can be a Mo/Si multilayer film intended for use at an EUV wavelength in the vicinity of 13 nm. The period length *(i.e.,* thickness of each layer-set or other unit group of layers) of the multilayer film is determined according to the operating wavelength of EUV light and the angle of incidence of the EUV light beam on the respective multilayer-film mirror. The angle of incidence varies with location of the respective multilayer-film mirror, even within the plane of a single mirror. Consequently, formation of the multilayer film must be performed while precisely controlling the film-thickness distribution so that the EUV beam can be reflected from the multilayer film extremely accurately and efficiently at any location on the mirror surface.

In the third step ("Assemble Optical System"), the multilayer-film mirrors are mounted to a lens column (housing). The wave aberration of the optical system is attributable not only to the respective form error (FE) of each multilayer-film mirror of the optical system but also to the assembly error of the optical system. The optical system can be assembled using either of two methods. In a first method, the system is assembled using components fabricated with extremely accurate mechanical tolerances and adjusted after assembly is completed. In a second method, the system is adjusted as assembly progresses.

To perform the second method of optical-system assembly, an interferometer (utilizing visible light such as produced by a He-Ne laser) can be used to measure the wave-front produced by a constituent mirror or other component of the optical system. The wave-front produced by EUV-wavelength light and the wave-front measured using visible light are not strictly the same, but the differences between these wave-fronts is relatively small, thereby allowing wave-front data obtained using visible light to be useful for making corrections and adjustments during assembly of the optical system.

In the fourth step ("Measure Wave-front"), the wave aberration of the assembled optical system is measured at the normal operating wavelength (EUV radiation) of the system. For example, if the optical system is to be used in an EUVL apparatus, wave aberration is measured using EUV light having a wavelength in the vicinity of 13 nm. Generally, a Fizeau interferometer can be used for wave-front measurements performed using light ranging from visible to ultraviolet wavelengths, but is not useful for EUV wavelengths because lenses cannot be used with these wavelengths. Thus, a different measurement method is required, such as PDI (Point Diffraction Interferometry; Goldberg et. al., *Proceedings SPIE* **3997**:867 (2000)), in which comparative measurements are performed using a diffraction wave-front produced by a pinhole. An alternative measurement method is shearing-interferometry *(e.g.,* Naulleau et. al., *Abstracts of the 44th International Conference on Electron, Ion and Photon Beam Technology and Nanofabrication*, p. 94 (2000)), which horizontally shifts and stacks wave-fronts produced by a multilayer film. Measurement of wave aberrations is performed at multiple points, rather than at a single point, within the optical field of the optical system so that the entire exposure field can be evaluated.

An EUV optical system normally has a bandwidth, compared with the operating wavelength of the system, that is too large to be ignored. For example, the bandwidth of a projection-optical system comprising six Mo/Si multilayer-film mirrors is 0.35 nm at a wavelength of 13.4 nm. A reflective-optical system theoretically does not exhibit chromatic aberration, but phase changes resulting from reflection from a multilayer film vary according to the wavelength. Hence, strictly speaking, wave aberration changes slightly according to the wavelength. *I.e.*, chromatic aberration attributable to the multilayer films occurs in such systems.

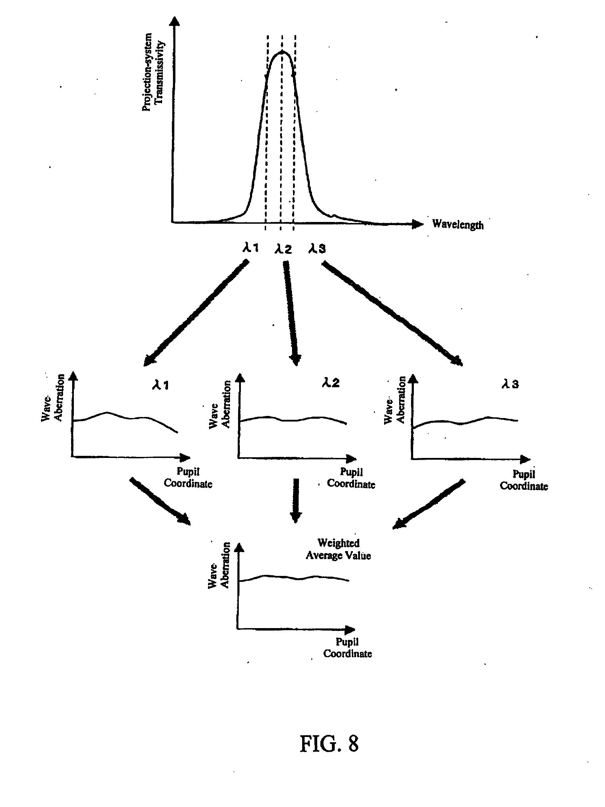

To perform optimization in a manner that takes this chromatic-aberration effect into account, measurement of wave aberration should be performed at multiple wavelengths rather than at a single wavelength. For example, as shown in FIG. 8, in addition to the peak-position wavelength $\lambda_2$ of the transmissivity of a projection-optical system, wave aberrations also are measured in the vicinity of $\lambda_1$ and $\lambda_3$ that differ slightly from $\lambda_1$. The measured wave aberration varies slightly depending upon the wavelength $\lambda_1$, $\lambda_2$, $\lambda_3$. From these individual wave aberrations, an average value is calculated, and the average is weighted according to the transmissivity of the optical system at the respective measurement wavelengths. The resulting weighted average is regarded as the wave aberration of the optical system. Thus, it is possible to obtain measurements of wave aberration that accurately reflect the actual characteristics of the optical system.

In any event, if the measured wave aberration is within prescribed limits, then assembly of the optical system is complete. If the limits are exceeded, then additional steps are performed, as follows. Specifically, in a fifth step ("Compute Correction Amount"), respective corrections to be made to the surfaces of respective multilayer-film mirrors are computed from the wave-front measurement data obtained in the fourth step.

To calculate the corrections, first the computed wave-fronts are divided into appropriate increments, taking into account the desired computation accuracy and the capability of the computer used to perform the calculation. The manner of dividing the wave-front may be such that the entire wave-front is divided equally or such that only the center portion of the wave-front is divided into small increments. The respective dislocation of the center of each increment from a corresponding aberration-free wave-front is $f_i = f_1, f_2, f_3, ..., f_n$. Next, the pupil of the EUV optical system is divided into incremental portions corresponding to the increments produced by dividing the wave-front. The optical-path lengths, from the object plane to the image plane, of respective light beams passing through the centers of the respective incremental portions are calculated. These respective optical path-lengths are denoted $g_i = g_1, g_2, g_3, ...., g_n$.

By changing, as required to make corrections, distances between mirrors, mirror inclinations, mirror eccentricities, mirror-surface profiles expressed by respective curvature radii, and mirror-surface profiles expressed by aspheric surface attributes or Zernike attributes, the optical path-lengths $g_1, g_2, g_3, ..., g_n$ are changed to $g'_1, g'_2, g'_3, ..., g'_n$. Here, an evaluation function (merit function) $\Phi$ is expressed as follows:

$$\Phi = \sum_{i=1}^{n} w_i \left( g'_i - g_i - f_i + k \right)^2 \qquad (6)$$

wherein $w_i = w_1, w_2, w_3, ..., W_n$ are the weightings applied in the calculations to the respective optical paths. Note that all values of $w_i$ may be 1; but, more realistically, they are set as demanded by circumstances such as whenever it is desired to emphasize light beams in the center of the pupil while de-emphasizing peripheral light beams.

In addition, k is a real number selected so that $\Phi$ is at a minimum, and is one of the unknowns in Equation (6). In Equation (6), if k is ignored, then the sum ($g'_i$ - $g_i$ - $f_i$ + k) becomes zero whenever the optical-path length is changed from $g_i$ to g'; by a "dislocation" $f_i$ from the respective location on the corresponding aberration-free wave-front. If this is possible with respect to all "i", then the wave aberration can be made zero for all the light beams. However, in actuality, this cannot be done, so $g'_i$ and k are determined by a least-squares method so that the value of $\Phi$ determined by Equation (6) is at a minimum.

Specifically, by performing optimization with the relative positions (including mirror-to-mirror intervals, mirror inclinations, and mirror eccentricities) of the mirrors and respective mirror shapes (curvature radii, aspheric-surface attributes, Zernike attributes, etc.) as parameters, the set of parameters that would bring the evaluation function $\Phi$ to a minimum is calculated. If differences are revealed between values in the set versus corresponding optimized parameters, then the differences represent correction amounts. Generally included in correction amounts calculated in this way are not only corrections of parameters relating to mirror shapes but also parameters relating to the relative positions of the mirrors.

After correction processing has been performed as required on the constituent multilayer-film mirrors, the mirrors are reincorporated into the lens column. If the respective positions of the mirrors in the column can be adjusted during assembly using respective adjustment mechanisms, adjustments may be performed according to the respective correction amounts, as calculated above, for parameters relating to the relative positions of the mirrors. If the column lacks mechanisms for adjusting relative positions of the mirrors, then the parameters relating to relative positions of the mirrors are regarded as fixed values. In the latter instance, the evaluation function $\Phi$ may be minimized by changing only those parameters relating to mirror shapes.

With respect to parameters relating to mirror shapes, components having rotational symmetry can be corrected using only the variables of curvature radius and aspheric-surface attributes. However, if the surface shape is defined by a system of orthogonal functions such as Zernike polynomials, it is possible to calculate complex correction amounts for mirrors that do not have rotational symmetry.

To simplify the foregoing explanation, a situation was described in which only one point within the field of the optical system is optimized. In actuality, wave aberrations are measured at multiple image-point locations within the field, and optimization is performed at all the locations so as to minimize wave aberration at all the locations. Specifically, the evaluation function $\Phi$ may be expressed as follows according to the sum of the incrementally divided pupil planes and the sum of the image points selected within the field:

$$\Phi = \sum_{i=1}^{n} \sum_{j=1}^{m} w_i \left( g'_{ij} - g_{ij} - f_{ij} + k_j \right)^2 \qquad (7)$$

In Equation (7), $g_{ij}$ is the calculated value of the optical-path length of a light beam, from among the light beams to undergo image formation at the image point j, passing through the $i^{th}$ increment of the divided pupil; $g'_{ij}$ is an unknown quantity at a new optical-path length that has been changed by varying mirror intervals, inclinations, eccentricities, curvature radii, aspheric-surface attributes, and mirror shapes; $f_{ij}$ is the actually measured value (at a dislocation from an aberration-free wave-front) of a light beam, from among the light beams to undergo image formation at the image point j, that passes through the $i^{th}$ increment of the divided pupil; $w_{ij}$ is the weight applied in calculations of the respective optical paths; and $k_j$ is the actual value selected so that $\Phi$ is always at a minimum, and is one of the unknowns in Equation (7).

As the calculation technique for determining the parameters used for minimizing the evaluation function $\Phi$ in Equations (6) and (7), it generally is possible to use a method similar to an optimization (minimization) algorithm used during lens design. For example, a "DLS" (damped least squares) method may be used. Alternatively, any of various recently developed optimization-calculation techniques can be used such as Simulated Annealing or the Genetic Algorithm.

In general optimization algorithms, a set of parameters suitable for minimizing the evaluation function is sought while continuously varying the parameters. However, when locally removing layer(s) of a multilayer film to correct the reflecting surface, the multilayer film usually is removed one layer-set at a time. Hence, actually executable correction amounts are not continuous, but rather are discrete. Even if a normal optimization calculation is performed and its approximate value used to perform correction of the surface shapes of mirrors, there is a risk of error accumulation, which will cause inadequate reduction of wave aberrations. Hence, whenever a parameter-optimization calculation is performed, with respect to parameters relating to mirror shape, it is preferable that the calculation be performed under the limitation that discrete values will not be used.

The correction-amount calculation described above is premised upon the wave aberration of the optical system being small before correction, at least to the extent that wave aberration changes approximately linearly with changes in the parameter. The range in which this premise holds can be estimated by a calculation, so the required specified values of the processing accuracy of the mirror substrate and assembly accuracy of the optical-system column should be determined in advance accordingly.

Next, referring again to FIG. 7, in a sixth step ("Multilayer-film Correction Processing"), surficial layer-set(s) (here, layer-pair(s)) of the multilayer film on each mirror requiring correction are removed locally as required to correct the mirror profile. As described above, the amount of multilayer film actually removed at a location desirably is larger by at least one decimal place than the effective amount by which the reflective surface is corrected, thereby achieving highly accurate profile correction.

Layer-removal can be performed according to any of the representative embodiments described above. Actual removal of layer material can be performed by polishing using a small polishing tool, an ion-beam machining (IBM) method, a chemical-vapor machining (CVM) method, or other suitable method. See, *e.g.*, Japan Patent Application No. 2000-321031.

Whenever an attempt is made to process a complex surface profile of a multilayer film having non-rotational symmetry expressed by Zernike polynomials or the like, it is necessary to determine accurately the reference-coordinate system for the surface of the subject mirror. For this reason, marks desirably are provided on the mirror surface on respective mirror planes outside the effective region of the reflective surface. The marks serve as reference coordinates for the mirror surface. The marks also can be used as reference coordinates for reproducing the eccentricities, azimuths, inclinations, etc., of the respective mirrors whenever adjustment of the optical assembly is performed.

During local removal of prescribed numbers of layer-sets from the multilayer film, it is desirable to monitor progress of the removal to ensure the desired correction is being made. For example, any of the first, second, third, and fourth representative embodiments can be used to achieve such monitoring. The initial surface shape can be determined, before commencing correction, using an interferometer. The depth of the processed locations can be measured using a mechanical or optical profiler. Another method involves using the periodic structure of the multilayer film itself to define contour lines. In the latter method, as the multilayer-film surface undergoes correction by localized "shaving" of layers, differently colored contours are created by the exposed layers of the respective substances used for forming the multilayer film. By performing image processing on the contour-line pattern, either visually or via electronic image pickup, it is possible to provide feedback as layer-removal progresses.

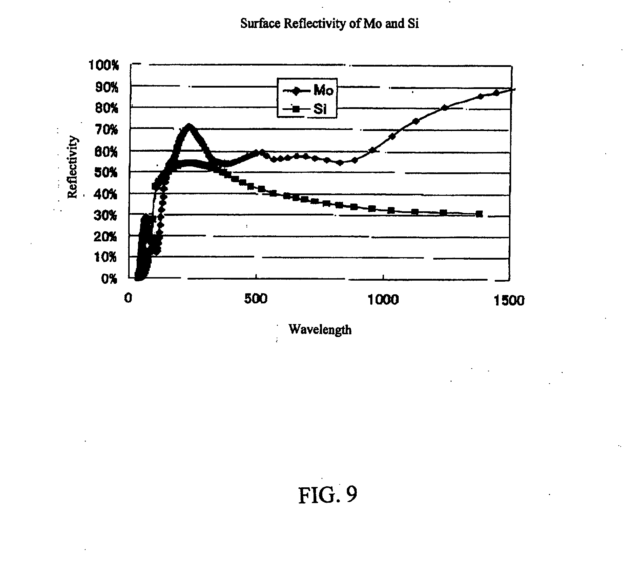

As a more specific example, FIG. 9 depicts the respective surface-reflectivity spectra of Mo and Si. From these plots, whenever visible or infrared light at a wavelength of 400 nm or more is used to observe the multilayer-film surface, it can be discerned that Mo and Si layers exhibit different reflectivity, allowing Mo surfaces to be distinguished from Si surfaces. These differences in reflectivity are manifest as contours. The difference in reflectivity increases with increasing wavelength. Hence, whenever image pickup and image processing are performed of light reflected from the multilayer-film surface, the light that is used desirably is infrared light at a wavelength in the range of 1,000 nm to 1,500 nm.

Upon completing the sixth step of the method shown in FIG. 7, a return is made to the third step in which the optical system is assembled. After completing the assembly, a measurement is made of wave aberration produced by the optical system (fourth step). If the measured wave aberration is within the specified range, then assembly of the optical system is regarded as completed. If the aberration exceeds specification, then the cycle of the fifth step, the sixth step, the third step, and the fourth step is repeated until the wave aberration of the optical system is within specification.

In reflective optical systems such as EUV optical systems, the respective external-shape profiles of mirrors usually must be configured so as not to block reflected light. For this reason, holes and/or cutouts can be provided in the mirrors. If holes and/or cutouts are formed in advance on a mirror substrate before the mirror substrate is machined to have the desired reflection surface, a phenomenon called "edge wear" tends to occur at the edges of the holes and cutouts during machining of the reflection surface. Edge wear deteriorates the accuracy of the mirror surface, and usually is caused by a faster polishing rate occurring at the edges of the holes and cutouts compared to other portions of the surface of the mirror substrate. As a result of edge wear, the desired accuracy of the reflective-surface profile can be impossible to achieve. If the reflection surface of the mirror substrate is machined first, then forming the holes and/or cutouts afterward can eliminate edge wear. However, in the latter instance, mirror-substrate deformation can occur due to the release of internal stresses as the holes and cutouts are being formed.

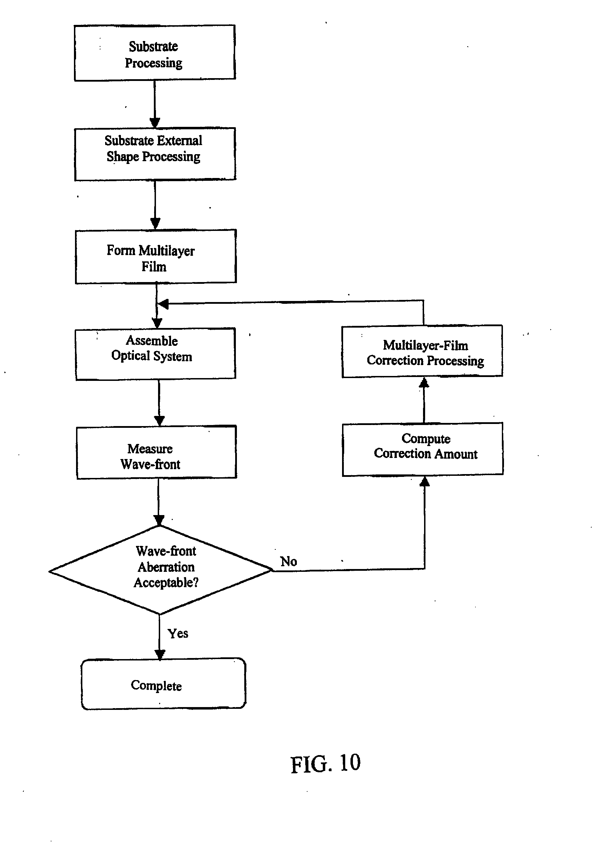

To solve this problem, the process shown in FIG. 10 can be performed. The process of FIG. 10 is similar to the process of FIG. 7, except that the FIG.-10 process includes an external-shape processing step (in which holes and/or cutouts are formed to provide the mirror with a desired external-shape profile) inserted between the substrate-processing step and the multilayer-film forming step. This method does not eliminate the occurrence of mirror-substrate deformation during external-shape processing. However, the effects of the deformation are corrected during the subsequent steps that are similar to those discussed above with reference to FIG. 7. Included in the results of wave aberration obtained in the method of FIG. 10 is a component attributable to the form error arising from deformation caused by forming the holes and/or cutouts. But, the downstream process, similar to that shown in FIG. 7, is performed so as to correct the deformation. Consequently, no adverse effects from forming the holes and/or cutouts are manifest on the ultimate performance of the optical system.

The following examples further illustrate this embodiment:

Example 1

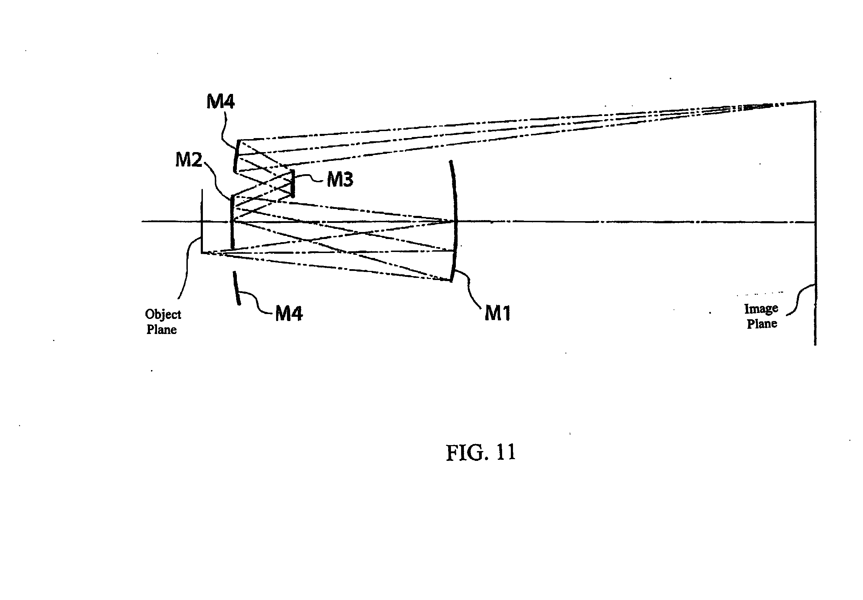

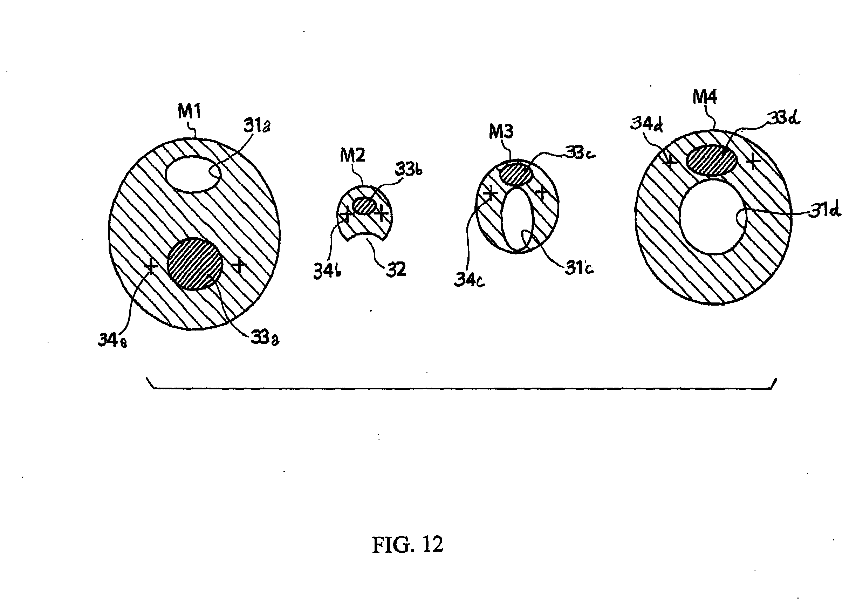

As shown in FIG. 11, the projection-optical system of this example consists of four aspheric mirrors M1, M2, M3, M4 and has a ring-field exposure region. The numerical aperture (NA) of the system is 0.1, and the magnification is 1/4. The luminous flux irradiated from the object plane is reflected sequentially by the mirrors MI, M2, M3, and M4 and undergoes image formation on the image plane. FIG. 12 shows the external profiles of the respective mirrors M1-M4. The mirrors M1, M3, M4 each define a respective aperture 31a, 31c, 31d through which the luminous flux can pass. The mirror M2 defines a cutout 32 that prevents blocking of luminous flux passing by the mirror M2. Each mirror M1-M4 has a respective effective region 33a-33d denoted by shading. Marks 34a-34d that serve as coordinate references for the mirrors M1-M4, respectively, are provided outside the respective effective regions 33a-33d.

First, mirror substrates for the respective aspheric mirrors M1-M4 were manufactured using conventional grinding and polishing technology. Polishing of each surface destined to receive a multilayer film was performed to an accuracy of approximately 0.5 nm (RMS). The coordinate reference marks 34a-34d were formed during a rough-grinding step.

After forming the mirror substrates, external-shape processing was performed on each mirror substrate, resulting in the formation of the apertures 31a, 31c, and 31d in the mirrors M1, M3, and M4, and the cutout 32 in the mirror M2. When the profiles of the respective mirror substrates were measured after performing external-shape processing, the accuracy of the surfaces destined to receive a multilayer film had deteriorated to 0.7 to 0.9 nm (RMS). This degradation arose because removing a portion of a mirror substrate causes release of internal stresses in the mirror substrate, resulting in corresponding deformation. Note that, in this example, surface-profile measurements were performed after external-shape processing; but, it is not necessary to perform surface-profile measurements at this stage.

Next, a Mo/Si multilayer film, optimized for an operating wavelength of 13.4 nm, was formed on the reflecting surfaces of each mirror substrate. The period length of the multilayer films was in the range of 6.8 to 7.3 nm, and the number of laminations of each respective multilayer film was optimized at 70 layer-sets (here, layer-pairs), which was suitable for the angles of incidence of EUV light on the mirrors M1-M4. The multilayer films were formed by ion-beam sputtering while controlling the distributions of film thickness.

Next, the multilayer-film mirrors M1-M4 were assembled in a lens column (housing) to complete assembly of the optical system. Assembly of the optical system was performed while relying only on the mechanical precision of the constituent parts. No adjustments were performed during assembly. As aids in assembling the optical system, the coordinate-reference marks 34a-34d were used so that the azimuths of the respective mirrors M1-M4 were always in the same direction. The lens column was configured so that the constituent mirrors M1-M4 could be attached and detached with good reproducibility.

Next, the wave aberration of the optical system at a wavelength of 13.4 nm was measured using a shearing interferometer employing a laser-plasma light source. Each measurement of wave aberration was performed at 15 discrete points within a circular arc-shaped field. The measured wave aberration ranged from 1.9 nm (RMS) to 2.5 nm (RMS).

Respective correction amounts for each of the mirrors M1-M4 were calculated from the measured wave aberrations of the optical system, according to methods described in this embodiment. Optimization was performed using, as parameters, 36 Zernike polynomials expressing the shapes of the respective mirrors M1-M4. Since the lens column lacked any adjustment mechanisms, parameters expressing the relative positions of the mirrors M1-M4 were not used as parameters in the optimization calculations.

Next, the mirrors M1-M4 were removed from the lens column, and surface-correction processing was performed on each mirror as required according to the computed correction amounts. A small-tool polishing device was used for locally shaving layer-sets from the multilayer-film surfaces. As described in the fourth representative embodiment, visible-light images of the reflective surfaces were obtained using a CCD camera. In each image, a contour map of Mo versus Si was observed, allowing the progress of layer-shaving to be monitored. During this monitoring, the respective coordinate-reference marks 34a-34d were used as in-plane coordinate references.

Next, the mirrors M1-M4 were reassembled into the lens column, and wave aberrations were again measured at a wavelength of 13.4 nm.

Based on the measured wave aberrations, correction processing of the respective mirrors and wave-front measurements of the reassembled optical system were repeated as required to reduce the wave aberration of the optical system to 0.5 nm or less (RMS) at all points within the field.

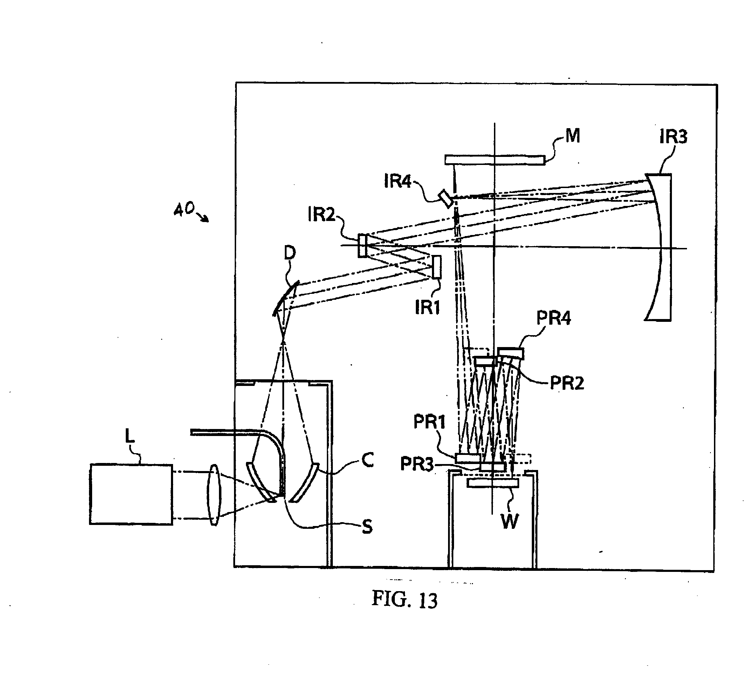

FIG. 13 depicts the projection-optical system, manufactured as described above, incorporated into an EUVL apparatus 40. Assembled in this manner, an exposure test of the projection-optical system was performed. In the EUVL apparatus, IR1, IR2, IR3, and IR4 are the mirrors of the illumination-optical system, and PR1, PR2, PR3, and PR4 (corresponding to the mirrors M1, M2, M3, and M4, respectively) are the mirrors of the projection-optical system. W is a wafer, and M is a reflective reticle.

Laser light irradiated from a laser light source L is focused at a target S. The resulting plasma formed at the target S generates EUV radiation. The EUV radiation is reflected by reflecting mirrors C and D and is incident to the illumination-optical system as a collimated EUV flux. The EUV flux is reflected sequentially by the mirrors IR1-IR4 of the illumination-optical system to illuminate a selected region on the reticle M. EUV flux reflected from the pattern on the reticle M is reflected sequentially by the mirrors PR1-PR4 of the projection-optical system, which forms a resolved image of the pattern on the surface of the wafer W. With this EUVL apparatus, fine patterns were imaged at a resolution of up to 50 nm L&S (lines and spaces).

Example 2

In this example, the subject projection-optical system consisted of six aspheric mirrors collectively having a numerical aperture (NA) of 0.25, a magnification of 1/4, and a ring-field exposure region.

First, the respective aspheric mirrors were manufactured by conventional grinding and polishing technology. Then, substrate-external-shape processing was performed on the mirror substrates, resulting in formation of respective apertures and cutouts as required in the mirror substrates.

Next, Mo/Si multilayer films, optimized for an operating wavelength of 13.4 nm, were formed on the reflecting surfaces of the mirror substrates. The period length of the multilayer films was in the range of 6.8 to 7.5 nm, and each multilayer film had 70 layer-sets, which was optimized to match the angles of incidence of EUV light on respective locations on the reflective surfaces of the mirrors. The multilayer films were formed by ion-beam sputtering while controlling the distribution of film thickness. Using respective masks, the multilayer films were formed only on effective regions of the respective mirror substrates. Also, marks for use as coordinate references were formed outside the effective regions.

The multilayer-film mirrors were assembled in a lens column (housing) that included adjustment mechanisms allowing fine adjustment of the mirror-to-mirror intervals, mirror eccentricities, mirror inclinations, etc. Respective adjustments of this nature were determined by respective micrometer heads provided with each adjustment mechanism. A Fizeau interferometer employing a He-Ne laser as a light source was used to provide observable wave-front data obtained with visible light. This data was consulted while making the adjustments. During assembly of the optical system, the coordinate-reference marks were used to ensure that the azimuths of the respective mirrors were oriented properly. (The coordinate-reference marks may be used not only for ascertaining azimuth orientations but also for measuring mirror eccentricities and inclinations.) The lens column was configured to allow reproducible attachment and detachment of the mirrors.

The wave aberration of the optical system was measured, at a wavelength of 13.4 nm, using a PDI (Point Diffraction Interferometer) employing an irradiated-light (undulator) source of EUV radiation. Wave-aberration measurements were performed at 15 discrete points within a circular arc-shaped field. At the respective measurement points, measurements of wave aberration were performed at three wavelengths: 13.2 nm, 13.4 nm, and 13.6 nm. The transmissivity of the optical system at the respective wavelengths was weighted and average values were determined. The measured wave aberrations ranged from 1.7 nm (RMS) to 2.4 nm (RMS).

From the measured wave aberrations, respective correction amounts for the multilayer-film mirrors were calculated as described earlier in this embodiment. Optimization was performed using, as parameters, 81 Zernike polynomials expressing the respective profiles of the respective mirrors. The optimization-calculation parameters included, in addition to the coefficients of the Zernike polynomials expressing the respective mirror shapes, the mirror-to-mirror intervals, mirror eccentricities, and mirror inclinations expressing the relative positions of the mirrors.

The respective mirrors were removed from the lens column, and multilayer-film surface-correction processing was performed as required according to the computed correction amounts. A small-tool polishing apparatus was used for locally shaving off layer-sets. Meanwhile, a visible-light image of the mirror surface was taken using a CCD camera (see the fourth representative embodiment). Mo regions and Si regions on the surface were observed during processing to determine the status of processing as local layer-removal progressed. During this step, the coordinate-reference marks were used as in-plane coordinate references.

The mirrors were again assembled into the lens column, and the wave aberrations of the system were measured at a wavelength of 13.4 nm. As required, further respective correction processing of the mirrors and wave-front measurements of the optical system were repeated until the wave aberration of the optical system was reduced to 0.4 nm (RMS) or less at all points within the field.

After incorporating this projection-optical system into an EUVL apparatus, exposure tests revealed an ability of the apparatus to resolve fine patterns to 30 nm L&S.

Seventh Representative Embodiment

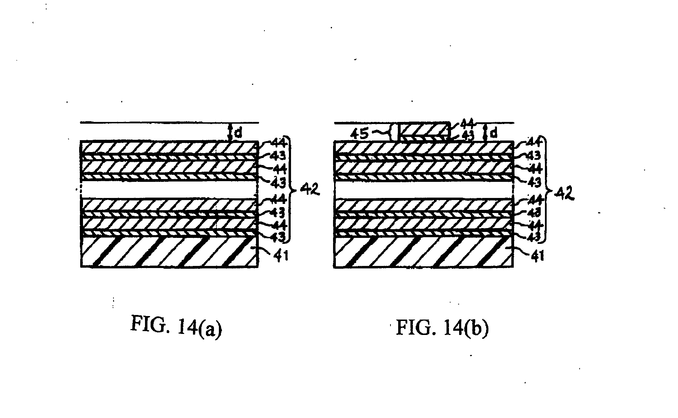

FIGS. 14(a) and 14(b) are respective elevational sections of a multilayer-film mirror, depicting a method, according to this embodiment, for manufacturing such a mirror.

As noted above, the change in the optical-path length of a multilayer film whenever a layer has been removed is expressed using Equation (5), wherein, from Equations (3) and (4):

$$\Delta = OP' - OP = n_o d - (n_A d_A + n_B d_B)$$

The change in optical-path length resulting from the addition of a layer also can be determined using the expression above.

Referring now to FIG. 14(a), a multilayer film 42 is formed in which two types of substances, 43 and 44 (corresponding to substances A and B, respectively), are laminated alternatingly on a mirror substrate 41 at a fixed period length d. As shown in FIG. 14(b), an additional layer-set 45 is added at a prescribed region on the surface of the multilayer film 42.

In FIG. 14(a), the optical-path length of the denoted space having thickness "d" is given by $OP' = n_o d$ with respect to a light beam impinging perpendicularly to the surface of the multilayer film 42. The variable "$n_o$" is the refractive index of a vacuum, wherein $n_o = 1$. In FIG. 14(b), the optical path length of the additional layer-set 45 having a thickness "d" (representing a layer-set formed at a prescribed location on the surface of the multilayer film 42) is given by $OP = n_{43} d_{43} + n_{44} d_{44}$. Here, $d_{43}$ and $d_{44}$ indicate the thicknesses of the respective layers 43 and 44, wherein $d_{43} + d_{44} = d$. The variables $n_{43}$ and $n_{44}$ are the refractive indices of the substances 43 and 44, respectively. By forming one or more additional layer-sets 45 on the surface of the multilayer film 42, the optical distance traversed by an impinging light beam on the surface of the additional layer-set 45 also changes relative to the optical distance traversed by an impinging light beam on the surface of the multilayer film 42. The change in the optical path length (that is, the change in the surface shape) is given by

$$\Delta' = OP - OP' = (n_{43} d_{43} + n_{44} d_{44}) - nd = -\Delta$$

Thus, it is possible to change the optical-path length at the same pitch as in layer-removal.

In this regard, consider an example involving a Mo/Si multilayer film usable at an EUV wavelength of 13.4 nm. With directly (normal) incident light, d = 6.8 nm, $d_{Mo} = 2.3$ nm, and $d_{Si} = 4.5$ nm. The respective refractive indices at these wavelengths are $n_{Mo} = 0.92$ and $n_{Si} = 0.998$. Calculating the change in optical-path length using these figures yields OP = 6.6 nm, OP' = 6.8 nm and $\Delta = 0.2$ nm. Thus, a correction of the surface profile, equivalent to 0.2 nm, can be performed by adding a 6.8-nm thick layer-set.

An exemplary method, according to this embodiment, of adding one or more layer-sets to a multilayer film to impart a wave-front correction is performed as follows. First, one or more masks are configured that defines opening (s) only in regions of the reflective surface of the multilayer film in which the additional layer-set(s) are to be added. Each mask desirably is made of a thin metal plate in which the opening(s) are formed by etching. Desirably each mask is made of a material that does not allow adhesion of the material(s) used for forming the additional layer-set(s) on the multilayer-film surface and is stable in a vacuum. Any of various metals satisfy these criteria. Each mask is placed individually above the multilayer film such that the opening(s) in the mask are aligned with the respective intended location(s) of the additional layer-set(s).

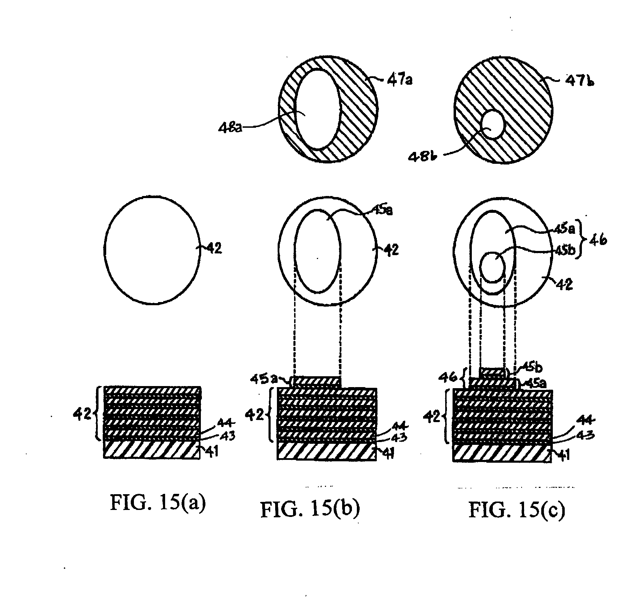

If the number of additional layer-sets is intended to vary depending upon the respective locations, on the multilayer-film surface, in which additional layer-set(s) are to be added, then multiple masks desirably are used. Each mask defines respective aperture(s) having respective shapes that correspond with the respective shapes of regions intended to have one, two, three, or more additional layer-sets, respectively. This is shown in FIGS. 15(b)-15(c), showing masks (hatched items at the top of the figures) for forming one and two additional layer-sets (here, layer-pairs), respectively. FIG. 15(a) shows the multilayer-film surface before adding any additional layers, and FIGS. 15(b)-15(c) show addition of one and two layer-pairs, respectively. The center portion of each figure shows the contours of additional layer-pairs on the surface of the multilayer film 42 (FIG. 15(a) lacks any contours because no additional layer-pairs are intended.) The lower portion of each figure is an elevational section of the respective multilayer-film mirror.

As described elsewhere above, the multilayer-film mirror shown in FIG. 15(a) is prepared having a mirror substrate 41 on which a multilayer film 42 is formed by alternatingly laminating two substances 43 and 44 having different respective refractive indices (see FIG. 14(a)). The layer-sets (each consisting of a respective layer of substance 43 and a respective layer of substance 44) have a prescribed period length d.

The mirror is assembled into an EUV optical system in which the mirror is intended to be used. The wave-front-aberration profile of the optical system is determined, as described above, interferometrically at a wavelength of 13 nm (*i.e.*, the intended wavelength at which the optical system will be used). From the obtained interferogram, a calculation is made to determine locations and magnitudes of respective corrections to be made to the wave aberration of the mirror. The results of the calculations include a determination, for each location at which correction is required, of the number of additional layer-sets to be added to the respective location to achieve the respective local correction.

Next, correction processing is performed on the subject mirror, using the respective masks, to add one or more layer-sets to each identified location on the surface of the multilayer film 42. For example, in a film-formation chamber (not shown), a mask 47a (FIG. 15(b)) is placed adjacent (but not contacting) the surface of the multilayer film 42 (FIG. 15(a)). The mask 47a is arranged relative to the surface of the multilayer film 42 such that the aperture 48a in the mask 47b is situated as shown in the middle of FIG. 15(b). Using the mask 47a as a guide, a layer-set (here, a layer-pair) 45a of the substances 43, 44 is formed on the surface of the multilayer film 42 (FIG. 15(b)). Thus, the additional layer-pair 45a is formed only in the desired region as defined by the mask 47a.

Next, in the film-formation chamber, the mask 47a is replaced with the mask 47b, which defines an aperture 48b corresponding to a region, on the layer-pair 45a, intended to receive a second layer-set (here, layer-pair) 45b (FIG. 15(c)). The mask 47b does not contact the surface of the multilayer film 42. Using the mask 47b as a guide, the second layer-pair 45b is formed on the first-added layer-pair 45a. Thus, the second layer-pair 45b is formed only in the desired region as defined by the aperture 48b in the mask 47b, yielding a multilayer-film additional portion 46 consisting of the first additional layer-pair 45a and the second additional layer-pair 45b.

In this example, non-contacting masks 47a, 47b are used to guide the localized formation of the additional layer-pairs 45a, 45b, respectively, on the surface of the multilayer film 42. The non-contacting masks prevent damage being imparted to the multilayer film 42 during formation of the additional layer-pairs 45a, 45b, in contrast with conventional methods. Thus, drops in reflectivity resulting from multilayer-film damage are reduced substantially.

In the description above, the mask 47b is inserted into the film-formation chamber and situated relative to the multilayer-film mirror after the mask 47a is removed from the chamber. Alternatively, it is possible to contain both masks 47a, 47b in the chamber and manipulate the masks to and from the multilayer-film mirror using a robotic mechanism. For example, multiple masks having differently shaped apertures 48a, 48b can be retained inside the chamber in a row or circle array, and selectively slid or rotated into position relative to the multilayer-film mirror as required, depending upon the number of additional layer-sets to be added.

Also, even though non-contacting masks 47a, 47b were used in the example above, this not intended to be limiting. The additional layer-sets 45a, 45b can be added selectively using other guides. For example, if the shape of the region destined to receive an additional layer-set has a complicated profile, then a resist pattern applied directly to the surface of the multilayer film 42 can be used as a mask. The resist can be applied and then patterned using an EB-writing method.

Another alternative method by which additional layer-set(s) can be formed selectively on the multilayer-film surface is photo-CVD (Chemical Vapor Deposition). In this method light that promotes a layer-forming reaction is focused into a beam having a desired transverse profile. The beam is made incident on the multilayer-film surface at the desired location while layer-forming reactants are introduced into the vicinity of the incident beam. This method can eliminate any need to use a jig for positioning a mask correctly relative to the multilayer-film mirror, while still allowing the additional layer-set(s) to be formed at any desired location on the multilayer-film surface.

Yet another alternative method by which additional layer-set(s) can be formed selectively on the multilayer-film surface is use of a film-formation device as described in Japan *Kôkai* Patent Document Nos. *Hei* 10-26698 (1998) and *Hei* 10-30170 (1998). These devices place a film-thickness-correction member, having a desired shape, between the multilayer film and a layer-material source. By moving the correction member appropriately (*e.g.*, rotation or other suitable movement at an appropriate velocity) during film formation, a desired distribution of film thickness is achieved on the multilayer-film surface.

In yet another alternative method, a desired number of additional layer-set(s) can be added to the multilayer-film surface in selected locations using a mechanism that monitors layer-formation *in situ.* For example, any of the mechanisms described in the first, second, third, and fourth representative embodiments described above can be used. Thus, layer-addition can be halted upon reaching an optimal correction for the respective location.

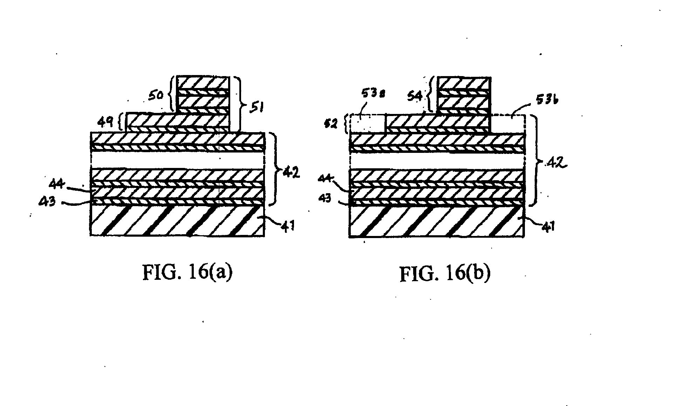

FIG. 16(a) is an elevational section showing a multilayer-film mirror manufactured by adding first and second multilayer-film portions as described above. Specifically, first, a multilayer film 42 is formed, comprising alternating layers of two types of substances having different refractive indices, on a mirror substrate 41. The multilayer film 42 has a prescribed period length d. Next, a first additional layer-set (here, a layer-pair) 49 is formed at a prescribed location on the surface of the multilayer film 42, and two additional layer-sets 50 are formed at a prescribed location on the surface of the first additional layer-set 49. Thus, an additional multilayer-film portion 51, consisting of the first additional layer-set 49 and the additional layer-sets 50, is formed.

FIG. 16(b) is an elevational section of a multilayer-film mirror manufactured using an alternative method for forming additional layer-sets at selected locations. Note that the multilayer-film mirror of FIG. 16(b) has the same configuration as the multilayer-film mirror of FIG. 16(a). In FIG. 16(b) the subject mirror is manufactured by a method involving selective removal of one or more layer-sets combined with selective addition of one or more layer-sets. The method of FIG. 16(b) is preferred in instances in which the amount of material added or removed is small.

The multilayer-film mirror of FIG. 16(b) comprises a mirror substrate 41 on which is formed a multilayer film 42 consisting of an alternating laminate of two types of substances 43, 44 having different refractive indices. The layers are formed as multiple layer-sets each having a prescribed period length d. The resulting multilayer-film mirror is assembled into an optical system, in which wave aberrations are measured interferometrically at a wavelength of 13 nm. From the interferogram, a calculation is made to determine correction(s) to be made to the reflection wave-front of the mirror so as to reduce the wave aberration of the optical system. The calculations also reveal locations on the mirror from which at least one layer-set is to be removed or added to achieve the desired wave-front correction. The mirror is subjected to correction processing to remove or add layer-set(s) in the selected locations, based on the calculation results.

Specifically, after removing the prescribed area(s) 53a, 53b of the layer-pair 52 from the surface of the multilayer film 42 using an ion beam, for example (see above), two layer-pairs 54 are added, in the manner described above, to selected location(s) on the surface of the remaining portions of the layer-pair 52. For example, the layer-pairs 54 can be added using a non-contacting mask as a guide, as described above.

As the prescribed portions 53a, 53b of the layer-pair 52 are being removed, and as the layer-pairs 54 are being formed, it is desirable that monitoring be performed *in situ,* as described in other representative embodiments above, as material is being removed and added, respectively. Such monitoring allows correction processing to be halted immediately when the optimal amount of material has been removed or added, respectively.

A multilayer-film mirror produced according to this representative embodiment can be used, for example, in an EUVL apparatus as shown in FIGS. 6 or 13, and described previously above.

Although this embodiment has been described in the context of a Mo/Si multilayer film for use at an EUV wavelength of 13.4 nm, the embodiment is not so limited. The principles set forth in this embodiment are equally applicable to other multilayer-film materials and to uses of the resulting multilayer-film mirror at any of various other wavelengths. In addition, it is not necessary that the material forming the second multilayer film of an upper layer-set be the same as the material forming the first multilayer film of a lower layer-set.

Example 3

This example was directed to a projection-optical system for an EUVL apparatus. The subject projection-optical system comprised six aspheric multilayer-film mirrors, and had a ring-field exposure region with a numerical aperture (NA) of 0.25 and a magnification of 1/4.

First, the respective aspheric mirror substrates were manufactured using conventional grinding and polishing technology. On the mirror substrates, each reflective-surface profile was shaped to an accuracy of 0.5 nm (RMS). The mirror substrates were assembled into a lens column (housing). The measured wave-front aberration of the assembly was 2.4 nm (RMS). For use at a wavelength of 13.4 nm, it was deemed necessary to limit the wave aberration to approximately 1 nm (RMS) or less. Hence, the initial wave aberration was unsatisfactory.

The mirror substrates were removed from the lens column, and a Mo/Si multilayer film was formed on each reflective surface. First, forty layer-pairs of $\Gamma$ 1/3 multilayer film were added, the layer-pairs having a period length of 6.8 nm. (Here, $\Gamma$ is the ratio of the thickness of the Mo layer to the period length of the multilayer film.) The multilayer film was formed by ion-beam sputtering.

Next, for each mirror, correction of the respective wave aberration was performed by selectively adding one or more layers to the multilayer film. For example, addition of a layer-pair having $\Gamma$ 1/3 and a period length of 6.8 nm changed the optical path length by 0.2 nm. The locations at which one or more additional layer-pairs were added, as well as the number of additional layer-pairs added, were calculated based on the results of the wave-front measurements of the respective mirrors. For each mirror, a respective mask was produced for defining (by respective apertures) the location(s) at which the additional layer-pairs were formed. Each mask was formed by etching a 0.2-nm thick stainless-steel plate. The regions of added layer-pair(s) were formed by ion-beam sputtering. Each of the resulting corrected mirrors exhibited a reflective-surface accuracy of 0.15 nm (RMS).

The corrected mirrors were assembled into the lens column, with adjustments made as required to keep wave aberration of the projection-optical system at a minimum. Thus, wave aberration of the system was reduced to 0.8 nm (RMS), which was adequate for achieving the desired diffraction-limited imaging performance.

In this example, since correction was performed by selectively adding one or more layer-pairs, any damage to the underlying multilayer film was prevented.

Example 4

This example was directed to a projection-optical system for use in an EUVL apparatus. Aspects similar to those described in Example 3 are not described further.

Mirror substrates were prepared and provided with respective multilayer-film coatings as described above. On the aspheric reflective surface of each of the constituent mirrors, additional Mo/Si layer-pair(s) were formed selectively by ion-beam sputtering, using a moving-mask technique. The magnitude of mask movement was determined based on the calculated results of wave-front-aberration measurements. Thus, one or more layer-pairs having $\Gamma$ 1/3 and a period length of 6.8 nm were added, which increased the accuracy of the reflective-surface profiles to 0.15 nm (RMS).

Example 5

This example was directed to a projection-optical system for use in an EUVL apparatus. Aspects similar to those described in Example 3 are not described further.

Mirror substrates were prepared and provided with respective multilayer-film coatings as described above. On the aspheric reflective surface of each of the constituent mirrors, additional Mo/Si layer-pair(s) were formed selectively by photo-CVD. Thus, one or more layer-pairs having $\Gamma$ 1/3 and a period length of 6.8 nm were added, which increased the accuracy of the reflective-surface profiles to 0.15 nm (RMS).

Example 6

This example was directed to a projection-optical system for use in an EUVL apparatus. Aspects similar to those described in Example 3 are not described further.

Mirror substrates were prepared and provided with respective multilayer-film coatings as described above. On the aspheric reflective surface of each of the constituent mirrors, areas requiring addition or removal of one or more layer-pairs were defined by EB writing on a respective resist layer (to form a respective mask). Using the mask as a guide, additional layer-pair(s) were formed by ion-beam sputtering, and one or more layer-pairs were removed by local layer-shaving. On shaved locations, if additional layer-pair(s) were to be added locally, a new resist pattern was applied, followed by formation of the requisite number of layer-pairs. Added layer-pairs had $\Gamma$ 1/3 and a period length of 6.8 nm. Thus, the accuracy of the reflective-surface profiles was improved to 0.15 nm (RMS).

Example 7

This example was directed to a projection-optical system for an EUVL apparatus. Aspects similar to those described in Example 3 are not described further.

Mirror substrates were prepared and provided with respective multilayer-film coatings as described above. Reflection wave-front corrections were performed by forming localized regions in which an additional one or more layer-pairs were added (each layer-pair being $\Gamma$ 1/3, having a period length of 6.8 nm, and changing the optical path length by 0.2 nm) or one or more layer-pairs were removed. The locations requiring layer-pair addition or deletion, and the number of layer-pairs to be added locally, were determined by measurement and calculation, as described above. Masks were fabricated for defining the locations of layer-pair addition or removal. Each mask was formed in a 0.2-nm thick stainless steel plate.

Layer-pairs were added by ion-beam sputtering, and layer-removal was performed by ion-beam machining (IBM). Layer-addition and layer-removal were monitored interferometrically. The processing apparatus included a sputtering portion and an interferometer portion. A drive mechanism was included for adjusting the angle and position of the subject mirror as required for layer-formation, layer-removal, and interferometric measurements. As layer(s) were being added and removed, it was possible to move the mirror to an interferometer-measurement position after adding or removing one layer-pair, so as to determine the resulting wave-front profile.

Thus, the accuracy of the reflective-surface profiles was improved to 0.15 nm (RMS).

In this example, by correcting the reflection wave-front profile by selectively forming or removing layer-pairs, the damage to the multilayer surface normally encountered in conventional corrective methods was avoided.

In any of Examples 3-7, above, incorporation of the subject projection-optical system into an EUVL apparatus conferred an ability of the EUVL apparatus to produce projected L&S patterns of 30 nm.

Eighth Representative Embodiment

This embodiment is directed to methods for manufacturing multilayer-film mirrors while achieving wave-aberration control. The methods exploit the principle that "shaving" one or more layers from the surface of the multilayer film causes the phase difference of EUV light reflected from the surface to change with the number of shaved layers. Thus, the reflection wave-front produced by an optical system comprising one or more such mirrors can be adjusted in a manner yielding improved optical performance of the system.

For example, consider a mirror having a Mo/Si multilayer film consisting of alternating layers of Mo and Si with a period length of 6.8 nm. Removing one layer-set yields a surface-profile correction equivalent to 0.2 nm. But, as explained previously, this correction mainly results from removing the 2.4-nm thick Mo layer. It is difficult to stop the process of removing a Mo layer when the remaining portion of the Mo layer reaches the prescribed thickness. In other words, the Mo is removed in 2.4-nm increments in this example. However, according to this embodiment, after removing a full thickness (e.g., 2.4 nm) of Mo, it is possible to add Mo back on so as to achieve the desired thickness of the Mo layer.

To explain further, consider a multilayer-film surface to be corrected to 0.46 nm. This correction corresponds to 5.5 nm of Mo that should be removed, which is equivalent to 2.3 layers of Mo each having a respective thickness of 2.4-nm. Since it is difficult to stop Mo-removal processing in the middle of a Mo layer, a conventional Mo removal process would result in removing only two or three discrete layers of Mo; not any partial-thickness layers of Mo. In other words, a conventional process would result only in removal of 4.8 nm or 7.2 nm of Mo, producing an "error" of -0.7 nm or +1.7 nm, respectively, relative to a desired removal of 5.5 nm of Mo ("+" indicates removal exceeding the desired target amount). These errors translate to respective surface-profile errors of 0.4 nm or 0.6 nm, respectively, yielding uncorrectable errors of -0.6 nm or +0.14 nm, respectively, with respect to the desired surface-profile correction of 0.46 nm.

In this embodiment, first, more than the required amount of Mo is removed. *I.e.*, Mo is removed to the full Mo layer past the target amount of Mo to be removed. Then, the excessively removed Mo (relative to the target Mo thickness to be removed to achieve the target correction) is added back. In the example described above, three Mo layers are removed (*i.e.*, three layer-sets from the multilayer film), and a 1.7-nm thick layer of Mo is laminated on to recover the excess 1.7 nm of removed Mo. Thus, the total amount of removed Mo is 7.2 nm - 1.7 nm = 5.5 nm, which is the target amount for achieving the desired correction of 0.46 nm to the surface profile of the mirror.

Adding back Mo can be performed using, for example, a focused ion beam (FIB) or by sputtering, the latter being performed using a shielding plate that spatially limits the range to be laminated. Both techniques exhibit respective constant lamination rates and easily yield the desired layer thickness in an appropriate lamination time.

Thus, by "correcting" excessive removal of a layers such as Mo layers, as conventionally achieved by removing only full-layer-thickness increments, it now is possible to correct, and thus control, wave aberrations more accurately and precisely.

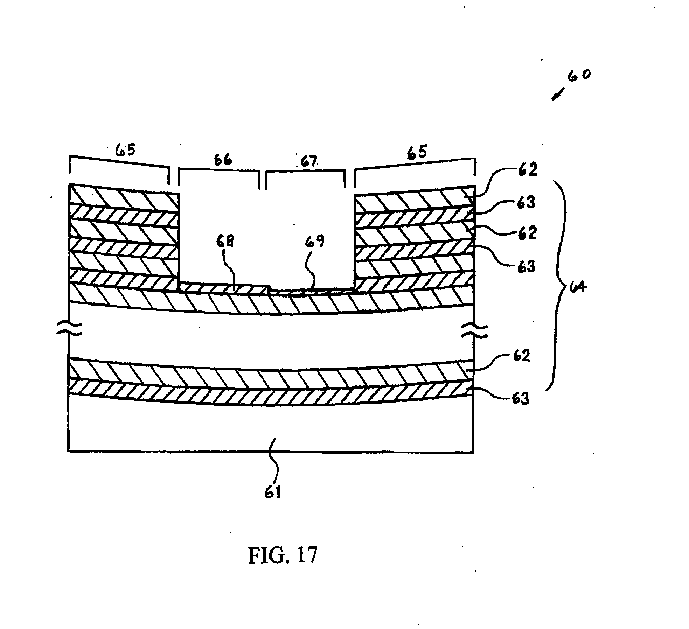

More specifically, reference is made to FIG. 17, showing a multilayer-film mirror 60 in which the number of layers depicted is smaller than an actual number of layers in a multilayer-film mirror. To produce the subject multilayer-film mirror 60, a suitable mirror substrate 61 is prepared by grinding and polishing to form the requisite surface-curvature profile. On the reflective surface of the mirror substrate 61 is formed a multilayer film 64 by alternatingly laminating, at the prescribed period length, two substances having different refractive indices. In this example, the period length of the multilayer film 64 is 6.8 nm, and comprises multiple layer-sets (here, layer-pairs) each consisting of a 4.4-nm thick Si layer 62 and a 2.4-nm thick Mo layer 63. The topmost layer is a Si layer 62.

After forming all the constituent multilayer-film mirrors for use in an EUV optical system (*e.g.*, for an EUVL apparatus), the mirrors are assembled into the intended optical system. The wave aberration for the entire optical system is measured interferometrically, as described above, at a wavelength of 13 nm (the intended wavelength with which the optical system will be used). From the interferogram, a calculation is made to determine the locations and amounts of "layer-shaving" corrections to be made to each mirror to correct the reflection wave-front of the system.

For example, referring further to FIG. 17, assume that regions 65 do not require any corrective processing, and that regions 66 and 67 are respective regions where corrective processing is required to correct wave aberration.

Assume further that the required correction for the region 66 is 0.46 nm, which requires local removal of 5.5 nm of Mo from the region 66, and that the required correction for the region 67 is 0.54 nm, which requires local removal of 6.5 nm Mo from the region 67.

To perform layer-removal processing on the multilayer film in the region 66, three layer-pairs are removed from the surface in this region. Thus, a total of 7.2 nm of Mo are removed. Next, a shielding plate (not shown) that spatially limits the film- formation area is positioned relative to the multilayer-film surface so as to leave exposed the region 66. Using the shielding plate as a spatial guide, Mo is applied to the exposed surface by ion-beam sputtering. By way of example, the rate at which Mo is applied to the exposed region is 0.03 nm per second, so approximately 56 seconds are required to form a 1.7-nm layer 68 of Mo in the region 66. Thus, in the region 66, the total amount of removed Mo is restored to the desired thickness of 5.5 nm, which is sufficient to achieve the desired surface-profile correction of 0.46 nm.

Layer-removal processing now shifts to the region 67, from which the top three layer-pairs are removed from the surface of the multilayer film 64. Thus, a total of 7.2 nm of Mo is removed from the region 67. Next, a shielding plate (not shown) is placed relative to the multilayer-film surface, leaving exposed the region 67. Using the shielding plate as a guide, a layer 69 of Mo is added to the region 67 by ion-beam sputtering. As noted above, this Mo layer 69 is formed at a rate of 0.03 nm per second, requiring a lamination time of approximately 23 seconds to produce a local Mo thickness of 0.7 nm. Thus, the added layer 69 of Mo produces a net reduction, in the region 67, in Mo thickness of 6.5 nm, which is sufficient to achieve the target surface-profile correction of 0.54 nm.

The resulting multilayer-film mirror 60 has a structure as shown in FIG. 17. The mirror comprises a mirror substrate 61 on which a multilayer film 64 is formed that comprises multiple layer-pairs of Mo 63 and Si 62 at a prescribed period length. The mirror includes, in this example, two processed ("shaved") regions 66, 67. In each region 66, 67, fully three layer-pairs were removed, and a respective partial-thickness Mo layer 68, 69 was laminated back on at respective thicknesses (that typically are thinner than the normal Mo thickness in a layer-pair). Thus, the surface profile of the region 66 is corrected by 0.46 nm, and the surface profile of the region 67 is corrected by 0.54 nm. The difference between these corrections is only 0.08 nm, which is small compared to the minimum of 0.2-nm correction units achievable using conventional methods in which layer-shaving is in units of layer-pairs only. Hence, this method achieves substantially greater correction accuracy than conventional methods.

A multilayer-film mirror according to this embodiment can be used in an EUVL apparatus such as shown in FIGS. 6 or 13, and described earlier above.

Various changes can be made in this embodiment. For example, the embodiment is not limited to multilayer-film mirrors for use in EUV optical systems operating at 13.4 nm. The principles of this embodiment are equally applicable to multilayer-film mirrors used with any of various other apparatus and wavelengths. It also is possible to use multilayer-film materials other than Mo and Si.

Ninth Representative Embodiment

In the various embodiments described above, layer-removal processing can leave residual abrupt edges of layers in the multilayer film. The abrupt edges can cause undesirably curvature and tilting of the wave-front reflected and formed by the multilayer film. As discussed above, the at least two types of substances that comprise the multilayer film each have a different refractive index. Hence, whenever the same amount is shaved in the respective substances, wave-front curvature inevitably occurs at the boundaries of the two types of substances. For example, whenever a Mo/ Si multilayer film is shaved at a certain inclination, since the phase hardly changes at all in the Si layer, the wave-front hardly ever becomes inclined in the Si layer. On the other hand, the phase changes substantially in the Mo layer, so the wave-front that is formed by the Mo layer is somewhat inclined.

To express this quantitatively, whenever the multilayer film is shaved at a certain inclination $\Delta$X', the inclination of the wave front that is formed is expressed as:

$$\text{wave-front inclination} = -2(1 - n) \cdot (\text{film inclination})$$

Hence, the wave-front inclination = $-2(1 - n)\Delta$X'. Here, n is the refractive index of the respective layer substance. Using this expression, the inclinations of wave-fronts reflected and formed in the respective layers are $(-0.004)\Delta$X' in the case of an Si layer and $(-0.16)\Delta$X' in the case of an Mo layer. Thus, the Mo layer is inclined at 40 times the Si layer, yielding an inevitable curvature of the wave-front.

In the manner described above, whenever there is a steep curvature in the wave-front reflected and formed by the multilayer-film mirror, scattering occurs. According to this embodiment, to eliminate curvature of the reflection wave-front formed by the multilayer-film mirror, the layers having a low refractive index *(i.e.,* the Mo layer in the case of an Mo/Si multilayer film) are processed to have gently sloping edges in shaved regions, and the layers having a high refractive index *(i.e.,* the Si layer in the case of an Mo/Si multilayer film) are processed to have steeply sloping edges. Thus, multilayer-film mirrors are produced that do not form steep curvatures in the wave-front formed by them and that do not exhibit scattering caused by wave-front curvature.

In addition, to make the differential value of the wave-front reflected and formed by the multilayer-film mirror continuous, local layer-removal processing ("layer-shaving") can be performed. Layer-removal processing is performed such that the ratio of the respective removal rates (*i.e.*, the processing rates during layer-removal processing) of the substances comprising the multilayer film is made equal to the ratio of the inverse of the difference between the vacuum refractive indices of the two substances and the refractive indices of the substances. By following this procedure, a smooth wave-front is obtained.

Specifically, consider two substances that comprise the multilayer film as substances A and B having respective refractive indices of $n_A$ and $n_B$. If the multilayer film is shaved at an angle, with the removal rates of the A layer and the B layer being $R/(1 - n_A)$ and $R(1 - n_B)$, respectively, then the inclination of the A layer will be $X'/(1 - n_A)$, and the inclination of the B layer will be $X'/(1 - n_B)$. Here, R is the unit-removal rate, and X' is the unit-inclination of the multilayer film. The inclination of the wave front formed by reflection from the multilayer film is given by -2(1 - n)(inclinations of the respective layers of the multilayer film). Hence, the wave-front inclination is -2X' for both the A layer and the B layer, which does not produce wave-front curvature at the boundary of the A layer and the B layer. Under such conditions layer-removal processing may be performed on the multilayer film while keeping the inclinations of the reflection wave-fronts from the edges of A layers and B layers nearly equal to each other.

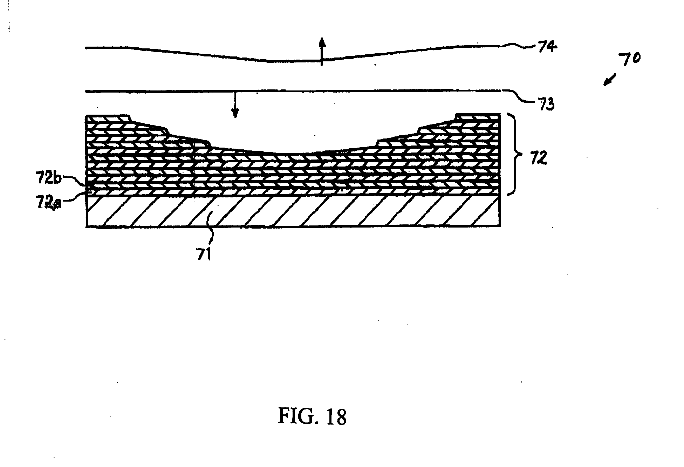

Referring now to FIG. 18, an elevational section of a multilayer-film mirror 70 subjected to layer-removal according to this embodiment is shown. The depicted mirror comprises a mirror substrate 71 and a multilayer film 72 formed thereupon. The multilayer film 72 is prepared by alternatingly laminating, at a prescribed period length, two or more types of substances having different respective refractive indices. In this instance, a Mo/Si multilayer film is shown, comprising multiple layer-pairs of Mo 72a and Si 72b. The Mo/Si multilayer film 72 exhibits high reflectivity at 13 nm, which is optimal for EUVL apparatus. The Mo/Si multilayer film is configured to have a period length suitable for maximally reflecting EUV light at 13 nm.

The depicted multilayer-film mirror 70 is one of multiple such mirrors of an EUV optical system as used, *e.g.*, in an EUVL apparatus. After forming the constituent multilayer-film mirrors and assembling them into the intended optical system, the wave aberration for the optical system is measured interferometrically at 13 nm. From the interferometric data, calculations are made to determine the locations and respective amounts of layer-shaving required for correcting the reflection wave-fronts produced by each of the multilayer-film mirror to reduce the wave aberration. Based on the calculations, layer-correction processing (localized layer-shaving) is performed that results in local removal of respective portions of the multilayer film 72. In the depicted example of FIG. 18 layer-removal has resulted in removal of layers from the center portion of the multilayer film 72. But, the edges of layers 72a, 72b remaining after removal of respective portions of such layers do not have abrupt edges. These edge configurations do not produce a steep curvature in the reflection wave-front formed by the multilayer-film mirror 70. Thus, the reflection wave-front exhibits little to no scattering otherwise caused by such curvature.

It is desirable that the ratio of the removal rates of the two substances 72, 72b forming the multilayer film 72 be equal to the ratio of the inverse of the difference between the vacuum refractive indices of the respective substances and the respective refractive indices of the substances. Hence, for example, in a Mo/Si multilayer film according to this embodiment, if the refractive indices of Mo and Si are denoted $n_{Mo}$ and $n_{Si}$, respectively, if the ratio of the removal rates of Mo and Si is $1/(1 - n_{Mo}) : 1/(1 - n_{Si}) = 12.5 : 500$, then a multilayer-film mirror is obtained that forms a smooth wave-front.

If the multilayer film 72 is shaved at an angle corresponding to the ratio of the aforementioned material-removal rates, then the inclination of the Mo layer will be $X'/(1-n_{Mo})$, and the inclination of the Si layer will be $X'/(1-n_{Si})$. The inclination of the wave-front formed by reflection from the multilayer film at this time is given by -2(1 - n)(inclinations of the respective layers of the multilayer film), yielding an inclination of -2X' for both the Mo layer 72a and the Si layer 72b. Thus, wave-front curvature does not occur at the boundaries of the Mo and Si layers.

It is desirable to use reactive-ion etching (RIE) for layer-removal processing of the multilayer film 72. RIE is desirable because this method generally exhibits different removal rates depending on the substance being removed. As a result, it is possible to measure the removal rate of individual layers while varying the processing conditions with respect to the Mo and Si that comprise the multilayer film 72 and to determine the processing conditions so that the removal rate is optimal.

So long as the layer-removal processing method exhibits different removal rates depending on the layer-substance, it is possible to perform layer-removal processing by a method other than RIE. For example, it is possible to use localized polishing under conditions in which the processing rates with respect to the respective layers are optimal.

Whenever a multilayer-film mirror manufactured in the manner described above is incorporated into an EUV optical system, wave-front curvature does not occur in the reflection wave-front 74 with respect to the incidence wave-front 73 at the boundaries of the Mo and Si layers (FIG. 18). Consequently, there is no scattering attributable to wave-front curvature, and good optical performance is obtained.

A multilayer-film mirror produced as described in this representative embodiment can be used, for example, in an EUVL apparatus as shown in FIG. 6 or FIG. 13 and described above.

Tenth Representative Embodiment

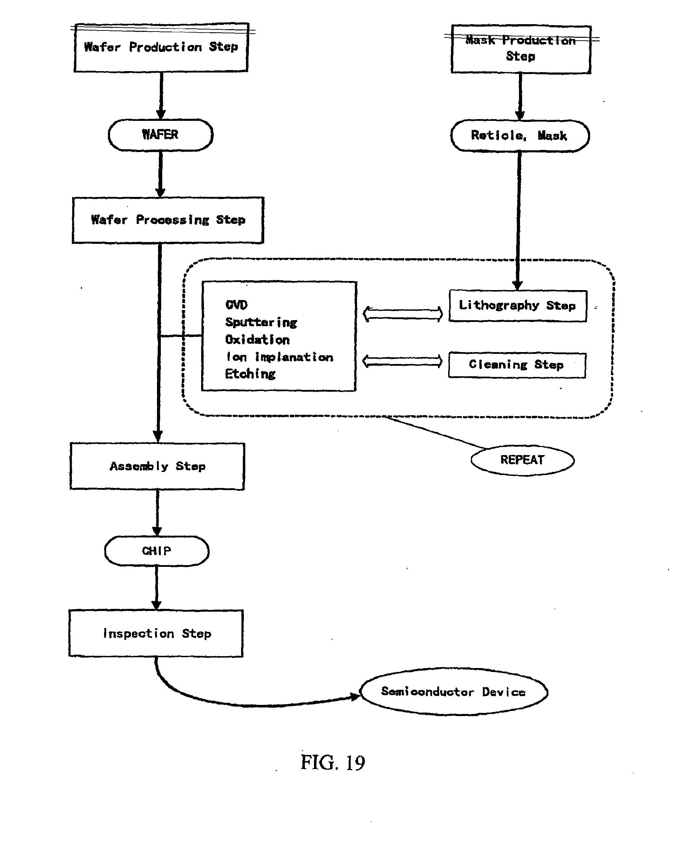

FIG. 19 is a flow chart of a microelectronic-device manufacturing method that includes a microlithography step performed using an EUVL apparatus as described herein. The depicted method generally comprises the main steps of wafer production (wafer preparation), reticle production (reticle preparation), wafer processing, device (chip) dicing and assembly, and inspection of completed chips. Each step usually comprises several sub-steps.

The wafer-preparation step results in production or preparation of a wafer suitable for use as a lithographic substrate. This step typically involves growth of a monocrystalline silicon ingot, cutting of the ingot into wafers, and polishing the wafers.

The reticle-preparation step results in production or preparation of a reticle that defines a desired pattern to be transferred lithographically to the wafer. Reticle-preparation involves forming a multilayer-film mirror, forming a pattern on the reflective multilayer film of the mirror, and correcting the reflected wave-front produced by the reflective surface.

Among the main steps, wafer processing is key to achieving the smallest feature sizes (critical dimensions), best inter-layer registration, and device performance. In the wafer-processing step, multiple circuit patterns are layered successively atop one another in each die on the wafer, wherein the formation of each layer typically involves multiple sub-steps. Usually, many operative microelectronic devices (chips or dies) are produced on each wafer.

Typical wafer-processing steps include: (1) Thin-film formation involving formation of a dielectric layer for electrical insulation or a metal layer for connecting wires. The films are produced by CVD, sputtering, or other suitable technique. (2) Oxidation of the thin-film layer or other portion of the wafer surface. (3) Microlithography to form a resist pattern, according to the reticle pattern, for selective processing of the thin film or the substrate itself. (4) Etching (*e.g.*, dry etching) or analogous step to etch the thin film or substrate according to the resist pattern. (5) Doping as required for implantation of dopant ions or impurities into the thin film or substrate according to the resist pattern. Doping can include a thermal treatment to facilitate diffusion of the impurity. (6) Resist stripping to remove the resist from the wafer. (7) Wafer inspection. Wafer processing is repeated as required (typically many times) to fabricate the desired microelectronic devices on the wafer.

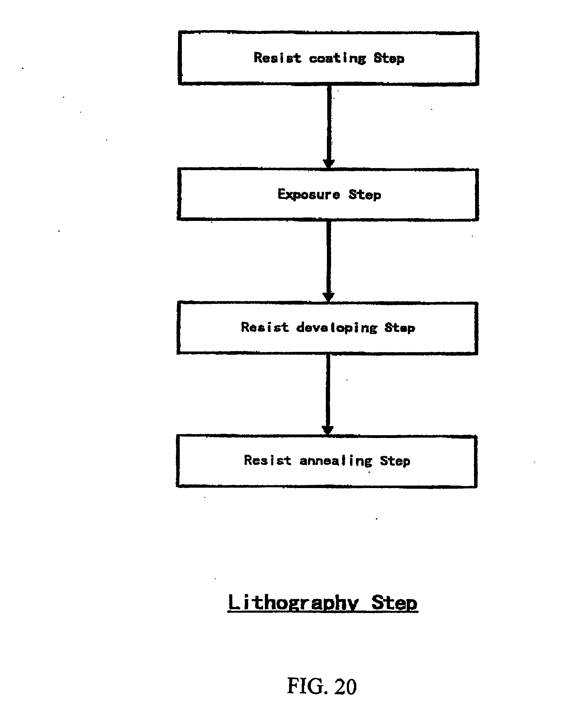

FIG. 20 is a flow chart of typical steps performed in microlithography, which is a principal step in wafer processing. The microlithography step typically includes: (1) application of resist to the wafer, wherein a suitable resist is coated on the wafer substrate (which can include a circuit element formed in a previous wafer-processing step); (2) exposure step (using an EUVL apparatus as described above), to expose the resist with the desired pattern and form a latent image; (3) development step, to develop the exposed resist and obtain an actual pattern in the resist; and (4) optional annealing step, to stabilize the developed pattern in the resist.

Commonly known technology can be used for any of the steps summarized above, including the microelectronic-device manufacturing process, wafer-processing, and microlithography. Hence, detailed descriptions of these processes are not provided.

Whereas the invention has been described in connection with multiple representative embodiments and examples, it will be understood that the invention is not limited to those examples. On the contrary, the invention is intended to encompass all modifications, alternatives, and equivalents as may be included within the spirit and scope of the invention, as defined by the appended claims.

In the present specification "comprises" means "includes or consists of" and "comprising" means "including or consisting of".

The features disclosed in the foregoing description, or the following claims, or the accompanying drawings, expressed in their specific forms or in terms of a means for performing the disclosed function, or a method or process for attaining the disclosed result, as appropriate, may, separately, or in any combination of such features, be utilised for realising the invention in diverse forms thereof.

**Claims**

1.  An apparatus for removing one or more surficial layers of a multilayer film on a multilayer-film mirror so as to correct a reflection wave-front produced by the multilayer-film mirror, the multilayer film comprising multiple alternating layers of at least a first layer-material and a second layer-material having mutually different refractive indices with respect to a prescribed wavelength, the apparatus comprising:

a layer-removal device situated and configured to remove at least a respective portion of one or more surficial layers of the multilayer film; and
an analysis device situated and configured to analyze at least one of the removed layer-materials.

2. An apparatus according to claim 1, wherein the layer-removal device comprises an ion-beam-irradiation device situated and configured to direct a layer-ablating ion beam at a selected region of the surficial layer.

3. An apparatus according to claim 1 or 2, wherein the analysis device analyzes the at least one layer-material as the respective layer is being removed.

4. An apparatus according to claim 1 or 2, wherein the analysis device analyzes the at least one layer-material after the respective layer has been removed.

5. An apparatus according to any one of claims 1 to 4, wherein the analysis device comprises a mass analyzer.

6. An apparatus according to any one of claims 1 to 4, wherein the analysis device is configured to measure a surface-distribution of the layer materials.

7. An apparatus according to any one of claims 1 to 4, wherein the analysis device is a photoelectron spectrometer or Auger-electron spectrometer.

8. An apparatus according to any one of claims 1 to 4, wherein the analysis device comprises at least one ellipsometer.

9. An apparatus according to any one of claims 1 to 4, wherein the analysis device is configured to detect a difference in reflectivity of the multilayer-film surface to infrared, visible, or ultraviolet light.

10. An apparatus according to any preceding claim, further configured to control a rate or extent of layer removal based upon data provided by the analysis device.

11. A method for removing one or more surficial layers of a multilayer film on a multilayer-film mirror so as to correct a reflection wave-front produced by the multilayer-film mirror, the multilayer film comprising multiple alternating layers of at least a first layer-material and a second layer-material formed at a prescribed period length on a reflective surface of a mirror substrate, the first and second layer-materials having mutually different refractive indices with respect to a prescribed wavelength of incident light, the method comprising:

removing at least a respective portion of one or more surficial layers of the multilayer film; and
analyzing at least one of the removed layer-materials.

12. A method according to claim 11, wherein the layer-removal step is performed by directing a layer-ablating ion beam at a selected region of the surficial layer.

13. A method according to claim 11 or 12, wherein the analyzing step is performed as the respective layer is being removed.

14. A method according to claim 11 or 12, wherein the analyzing step is performed after the respective layer has been removed.

15. A method according to any one of claims 11 to 14, wherein:

the layer-removal step is performed by directing a layer-ablating ion beam, in a vacuum environment, at a selected region of the surficial layer; and
the analyzing step is performed in real time on volatile products produced by ablation of the respective layer.

16. A method according to any one of claims 11 to 15, wherein the analyzing step comprises performing a mass analysis of matter removed from the surface of the multilayer film.

17. A method according to any one of claims 11 to 15, wherein the analyzing step comprises obtaining a photoelectron spectrogram or Auger-electron spectrogram of the surface of the multilayer film.

18. A method according to any one of claims 11 to 15, wherein the analyzing step comprises performing an ellipsometric analysis of the surface of the multilayer film.

19. A method according to any one of claims 11 to 15, wherein the analyzing step comprises obtaining a differential reflectivity profile of the surface of the multilayer film to infrared, visible, or ultraviolet light.

20. A multilayer-film mirror, produced by a method according to any one of claims 11 to 19.

21. An EUV optical system, comprising a multilayer-film mirror according to claim 20.

22. An EUV lithography apparatus, comprising an EUV optical system according to claim 21.

23. An EUV lithography apparatus, comprising:

   an EUV source that produces an EUV beam;
   an illumination-optical system situated optically downstream of the EUV source and configured to guide the EUV beam from the EUV source to a pattern-defining reticle; and
   a projection-optical system situated optically downstream of the reticle and configured to guide the EUV beam from the reticle to a sensitive substrate;

   wherein at least one of the illumination-optical system, the reticle, and the projection-optical system comprises a multilayer-film mirror according to claim 20.

24. A method for producing a multilayer-film mirror for use with a prescribed wavelength of incident light, the method comprising:

   forming a reflection surface on a mirror substrate;
   forming a multilayer film on the reflection surface by forming a stacked laminate of multiple alternating layers of at least a first layer-material and a second layer-material at a prescribed period length suitable for rendering the reflection surface reflective to the incident light, the first and second layer-materials having mutually different refractive indices with respect to the prescribed wavelength;
   measuring a profile of a reflected wave-front produced by reflection of the incident light from the multilayer film;
   based on the measured profile of the reflected wave-front, directing a layer-removal force locally to the multilayer film so as to remove, at one or more specified locations on the multilayer film, at least a portion of a surficial layer of the multilayer film so as to reduce an aberration of the reflected wave-front;
   detecting the respective layer-material removed from the specified location; and
   based upon the detected removal of layer-material, controlling an amount of layer-material removed from the specified location to achieve a desired reduction of wave aberration of the reflected light.

25. A method according to claim 24, wherein:

   the step of directing a layer-removal force comprises directing a layer-ablating ion beam, in a vacuum environment, at a selected region of the surface of the multilayer film; and
   the detecting step is performed in real time on volatile products produced by ablation of the respective layer.

26. A multilayer-film mirror, produced by a method according to claims 24 or 25.

27. An EUV optical system, comprising a multilayer-film mirror according to claim 26.

28. An EUV lithography apparatus, comprising an EUV optical system according to claim 27.

29. An EUV lithography apparatus, comprising:

   an EUV source that produces an EUV beam;
   an illumination-optical system situated optically downstream of the EUV source and configured to guide the EUV beam from the EUV source to a pattern-defining reticle; and
   a projection-optical system situated optically downstream of the reticle and configured to guide the EUV beam from the reticle to a sensitive substrate;

wherein at least one of the illumination-optical system, the reticle, and the projection-optical system comprises a multilayer-film mirror as recited in claim 26.

30. A method for manufacturing a reflective optical system for use with a prescribed operating wavelength of light, the method comprising:

(a) forming a respective reflection surface on each of multiple mirror substrates;
(b) on each reflection surface, forming a respective multilayer film by forming a stacked laminate of multiple alternating layers of at least a first layer-material and a second layer-material at a prescribed period length suitable for rendering the respective reflection surface reflective to the incident wavelength, the first and second layer-materials having mutually different refractive indices with respect to the prescribed wavelength, thereby forming respective multilayer-film mirrors;
(c) assembling the multilayer-film mirrors into a housing for the optical system;
(d) measuring a wave aberration of the assembled optical system at the operating wavelength;
(e) from the measured wave aberration, computing respective wave-front corrections to be made to the constituent multilayer-film mirrors in the optical system;
(f) as required according to the computed respective wave-front corrections, selectively removing one or more layers from the multilayer-film surface of the respective multilayer-film mirrors so as to correct a reflective-surface profile of the multilayer-film mirror in a manner corresponding to the required respective wave-front correction; and
(g) sequentially repeating steps (e), (f), (c), and (d) as required until the wave aberration of the optical system does not exceed a predetermined specification.

31. A method according to claim 30, further comprising the step, between steps (a) and (b), of configuring each mirror substrate to have a respective desired external-shape profile.

32. A method according to claim 31, wherein the step of configuring the external-shape profiles of the mirror substrates comprises forming at least one hole or cutout in at least one of the mirror substrates.

33. A method according to any one of claims 30 to 32, wherein:

in step (b) each multilayer film is formed having a respective number of layer-sets; and
each layer-set comprises a respective layer of the first layer-material and a respective layer of the second layer-material; and
the respective number of layer-sets is greater than a minimum number of layer-sets required to obtain a prescribed reflectivity from the respective multilayer film plus a maximum number of layer-sets that would need to be removed from the respective multilayer film to achieve a respective desired wave-front correction.

34. A method according to any one of claims 30 to 33, wherein in step (d) the wave aberration is measured at a plurality of wavelengths.

35. A method according to any one of claims 30 to 34, wherein:

step (e) comprises computing a sum, within an incrementally divided pupil plane of the optical system, of an evaluation function, and computing correction amounts by an optimization routine resulting in minimization of the evaluation function; and
the evaluation function includes differences between a change in optical-path length resulting from correction of the optical system and a corresponding displacement of the measured wave-front from an aberration-free wave-front.

36. A method according to any one of claims 30 to 35, wherein the corrections calculated in step (d) include parameters relating to relative positions of the multilayer-film layers in the optical system and to respective reflective-surface profiles of the multilayer films of the multilayer-film mirrors.

37. A method according to any one of claims 30 to 36, wherein the corrections calculated in step (d) include only parameters relating to respective reflective-surface profiles of the multilayer films of the multilayer-film mirrors.

38. A method according to any one of claims 30 to 36, wherein:

the corrections calculated in step (d) include parameters relating to respective reflective-surface profiles of the multilayer films of the multilayer-film mirrors; and

the parameters relating to the respective reflective-surface profiles are expressed by respective systems of orthogonal functions.

**39.** A method according to claim 38, wherein the orthogonal functions are Zernike polynomials.

**40.** A method according to any one of claims 30 to 39, wherein:

step (e) comprises computing correction amounts by an optimization routine resulting in minimization of an evaluation function; and

the optimization routine comprises imposing a limitation that, in step (f), changes in respective reflective-surface profiles of the respective multilayer films are made only by locally removing layers in period-length increments from the multilayer film.

**41.** A method according to any one of claims 30 to 40, wherein step (f) comprises, while selectively removing one or more layers from the multilayer-film surface of the respective multilayer-film mirrors, observing an in-plane distribution of layers selectively removed, the observations being made by producing images of the multilayer-film surfaces using visible light or infrared light at a wavelength of 400 nm or more.

**42.** A method according to any one of claims 30 to 41, wherein step (f) comprises, while selectively removing one or more layers from the multilayer-film surface of the respective multilayer-film mirrors, performing an *in situ* monitoring of the removal in real time and using data produced by the monitoring to ensure respective desired amounts of material are removed at the respective desired locations on the multilayer-film surfaces.

**43.** A method according to any one of claims 30 to 42, wherein, in at least one of steps (c), (d), and (f), a coordinate-reference mark is used for aligning at least one multilayer-film mirror, the coordinate-reference mark being formed on the reflection surface of the multilayer-film mirror outside an effective reflection region of the multilayer-film mirror.

**44.** A reflective optical system, produced by a method according to any one of claims 30 to 43.

**45.** An EUV optical system, comprising a reflective-optical system according to claim 44.

**46.** An EUV lithography apparatus, comprising an EUV optical system according to claim 45.

**47.** A multilayer-film mirror, comprising:

a mirror substrate defining a reflection surface;

a multilayer film formed on the reflection surface, the multilayer film defining an effective region intended to be a region from which light of a desired wavelength is reflected from the multilayer-film mirror; and

a coordinate-reference mark situated outside the effective region.

**48.** A multilayer-film mirror according to claim 47, wherein the reflection surface is aspheric.

**49.** A multilayer-film mirror according to claim 47 or 48, configured to reflect EUV radiation incident at the effective region.

**50.** An EUV optical system, comprising a multilayer-film mirror according to claim 49.

**51.** An EUV lithography apparatus, comprising an EUV optical system as recited in claim 50.

**52.** An EUV lithography apparatus, comprising:

an EUV source that produces an EUV beam;

an illumination-optical system situated optically downstream of the EUV source and configured to guide the EUV beam from the EUV source to a pattern-defining reticle; and

a projection-optical system situated optically downstream of the reticle and configured to guide the EUV beam from the reticle to a sensitive substrate;

wherein at least one of the illumination-optical system, the reticle, and the projection-optical system comprises a multilayer-film mirror according to claim 49.

**53.** A method for manufacturing a multilayer-film mirror, comprising:

forming a first multilayer film on a surface of a mirror substrate, the first multilayer film having a prescribed period length and being formed by laminating multiple layer-sets each comprising alternating respective layers of at least two types of substances having mutually different refractive indices for a wavelength of light with which the mirror is to be used;
obtaining a profile of a reflected wave-front produced by reflection of the light from a surface of the first multilayer film, and identifying from the profile a wave aberration requiring reduction; and
based on the obtained profile, laminating to selected regions of the surface of the first multilayer film at least one layer-set of a second multilayer film, so as to correct the wave aberration.

**54.** A method according to claim 53, wherein the second multilayer film has a period length substantially equal to the period length of the first multilayer film.

**55.** A method according to claim 53 or 54, wherein the step of laminating the second multilayer film comprises:

situating a mask between the first multilayer film and a source of the second multilayer film, the mask defining at least one aperture corresponding to a selected region on the first multilayer film at which the at least one layer-set of the second multilayer film is to be laminated; and
using the mask as a guide, laminating the at least one layer set of the second multilayer film on the surface of the first multilayer film.

**56.** A method according to claim 53 or 54, wherein the step of laminating the second multilayer film comprises:

situating a mask between the first multilayer film and a source of the second multilayer film, the mask defining at least a portion of a selected region on the first multilayer film at which the at least one layer-set of the second multilayer film is to be laminated; and
while moving the mask and using the moving mask as a guide, laminating the at least one layer set of the second multilayer film on the surface of the first multilayer film.

**57.** A method according to claim 56, wherein the mask is moved by rotating the mask.

**58.** A method according to claim 53 or 54, wherein the step of laminating the second multilayer film comprises forming the second multilayer film at the selected regions by photo-CVD.

**59.** A method according to claim 53 or 54, wherein the step of laminating the second multilayer film comprises:

forming a resist layer on the surface of the first multilayer film, the resist being patterned so as to define at least a portion of a selected region on the first multilayer film at which the at least one layer-set of the second multilayer film is to be laminated; and
using the patterned resist layer as a mask, laminating the at least one layer set of the second multilayer film on the surface of the first multilayer film.

**60.** A method according to claim 53 or 54, wherein lamination of the second multilayer film comprises:

during lamination of the second multilayer film at the selected locations, monitoring said lamination *in situ;* and
based on data produced by the *in situ* monitoring, halting further lamination of the second multilayer film when a desired lamination amount is reached.

**61.** A multilayer-film mirror, manufactured according to a method according to any one of claims 53 to 60.

**62.** An EUV optical system, comprising a multilayer-film according to claim 61.

**63.** An EUV lithography apparatus, comprising an EUV optical system according to claim 62.

**64.** An EUV lithography apparatus, comprising:

an EUV source that produces an EUV beam;
an illumination-optical system situated optically downstream of the EUV source and configured to guide the EUV beam from the EUV source to a pattern-defining reticle; and
a projection-optical system situated optically downstream of the reticle and configured to guide the EUV beam from the reticle to sensitive substrate;

wherein at least one of the illumination-optical system, the reticle, and the projection-optical system comprises a multilayer-film mirror according to claim 61.

**65.** A method for manufacturing a multilayer-film mirror, comprising:

forming a first multilayer film on a surface of a mirror substrate, the first multilayer film having a prescribed period length and being formed by laminating multiple layer-sets each comprising alternating respective layers of at least two types of substances having mutually different refractive indices for a wavelength of light with which the mirror is to be used;
obtaining a profile of a reflected wave-front produced by reflection of the light from a surface of the first multilayer film, and identifying from the profile a wave aberration requiring reduction; and
based on the obtained profile, (i) removing at least one layer-set from selected locations of the surface of the first multilayer film and (ii) laminating to selected regions of the surface of the first multilayer film at least one layer-set of a second multilayer film, so as to correct the wave aberration.

**66.** A method according to claim 65, wherein the second multilayer film has a period length substantially equal to the period length of the first multilayer film.

**67.** A method according to claim 65 or 66, wherein lamination of the second multilayer film comprises:

during lamination of the second multilayer film at the selected locations, monitoring said lamination *in situ;* and
based on data produced by the *in situ* monitoring, halting further lamination of the second multilayer film when the *in situ* monitoring has revealed that a desired lamination amount is reached.

**68.** A method according to any one of claims 65 to 67, wherein removing at least one layer-set from selected locations of the surface of the first multilayer film comprises:

during removal of the at least one layer-set, monitoring said removal *in situ;* and
based on data produced by the *in situ* monitoring, halting further removal of the first multilayer film when the *in situ* monitoring has revealed that a desired amount thereof has been removed.

**69.** A multilayer-film mirror, produced according to a method according to any one of claims 65 to 68.

**70.** An EUV optical system, comprising a multilayer-film mirror according to claim 69.

**71.** An EUV lithography apparatus, comprising an EUV optical system according to claim 70.

**72.** An EUV lithography apparatus, comprising:

an EUV source that produces an EUV beam;
an illumination-optical system situated optically downstream of the EUV source and configured to guide the EUV beam from the EUV source to a pattern-defining reticle; and
a projection-optical system situated optically downstream of the reticle and configured to guide the EUV beam from the reticle to a sensitive substrate;

wherein at least one of the illumination-optical system, the reticle, and the projection-optical system comprises a multilayer-film mirror according to claim 69.

**73.** A multilayer-film mirror, comprising:

a mirror substrate defining a reflection surface;
a first multilayer film formed on the reflective surface, the first multilayer film having a prescribed period length and being formed by laminating multiple layer-sets each comprising alternating respective layers of at least two types of substances having mutually different refractive indices for a wavelength of light with which the mirror is to be used, the first multilayer film having a surface defining at least one location at which a respective portion of at least a topmost layer-set has been removed to reduce a wave aberration of light reflected from the multilayer-film mirror; and
a second multilayer film laminated to at least one selected location on the surface of the first multilayer film, the second multilayer film having a period length substantially equal to the period length of the first multilayer film to correct the reflected wave-front produced by the multilayer-film mirror.

**74.** A multilayer-film mirror according to claim 73, wherein the second multilayer film is laminated to at least one location on the first multilayer film at which a respective portion of at least a topmost layer-set has been removed.

**75.** An EUV optical system, comprising a multilayer-film mirror according to claim 73 or 74. .

**76.** An EUV lithography apparatus, comprising an EUV optical system according to claim 75.

**77.** An EUV lithography apparatus, comprising:

an EUV source that produces an EUV beam;
an illumination-optical system situated optically downstream of the EUV source and configured to guide the EUV beam from the EUV source to a pattern-defining reticle; and
a projection-optical system situated optically downstream of the reticle and configured to guide the EUV beam from the reticle to a sensitive substrate;

wherein at least one of the illumination-optical system, the reticle, and the projection-optical system comprises a multilayer-film mirror according to claim 73 or 74.

**78.** A method for manufacturing a multilayer-film mirror, comprising:

forming a multilayer film on a surface of a mirror substrate, the multilayer film having a prescribed period length and being formed by laminating multiple layer-sets each comprising respective alternating layers of at least a first substance and a second substance, the first substance exhibiting a relatively large difference in respective refractive index to EUV light relative to the refractive index of a vacuum, and the second substance exhibiting a relatively small difference in relative refractive index to EUV light relative to the refractive index of a vacuum;
obtaining a profile of a reflected wave-front produced by reflection of the light from a surface of the multilayer film, and identifying from the profile a wave aberration requiring reduction; and
based on the obtained profile, (i) removing at least one layer-set from at least one selected location on the surface of the multilayer film, so as to leave exposed at the selected location a next layer of the second material, and (ii) laminating to the exposed layer of the second material at the selected location an amount of the first material to a prescribed thickness that is less than a layer thickness of the first material in the multilayer film, so as to reduce the wave aberration.

**79.** A multilayer-film mirror, manufactured by a method according to claim 78.

**80.** An EUV optical system, comprising a multilayer-film mirror according to claim 79.

**81.** A multilayer-film mirror, comprising:

a mirror substrate defining a reflection surface;
a multilayer film formed on the reflection surface, the multilayer film having a prescribed period length and comprising multiple laminated layer-sets each comprising respective alternating layers of at least a first substance and a second substance, the first substance exhibiting a relatively large difference in respective refractive index to EUV light relative to the refractive index of a vacuum, and the second substance exhibiting a relatively small difference in relative refractive index to EUV light relative to the refractive index of a vacuum;

and
the multilayer film having a surface including a processed region serving to reduce a wave aberration of the multilayer-film mirror by correcting a wave-front reflected from the multilayer film, the processed region including a void formed by selective removal of at least one surficial layer-set of the multilayer film in the region, and a partial-thickness layer of the first material formed on a surface of the second material, the partial-thickness layer having a thickness that is less than a layer thickness of the first material in the multilayer film.

**82.** A multilayer-film mirror according to claim 81, wherein the first substance is molybdenum.

**83.** A multilayer-film mirror according to claim 81 or 82, wherein the second substance is silicon.

**84.** An EUV optical system, comprising a multilayer-film mirror according to any one of claims 81 to 83.

**85.** An EUV lithography apparatus, comprising an EUV optical system according to claim 84.

**86.** An EUV lithography apparatus, comprising:

an EUV source that produces an EUV beam;
an illumination-optical system situated optically downstream of the EUV source and configured to guide the EUV beam from the EUV source to a pattern-defining reticle; and
a projection-optical system situated optically downstream of the reticle and configured to guide the EUV beam from the reticle to a sensitive substrate;

wherein at least one of the illumination-optical system, the reticle, and the projection-optical system comprises a multilayer-film mirror according to any one of claims 81 to 83.

**87.** A method for manufacturing a multilayer-film mirror, comprising:

forming a multilayer film on a surface of a mirror substrate, the multilayer film having a prescribed period length and being formed by laminating multiple layer-sets each comprising respective alternating layers of at least a first substance and a second substance, the first substance exhibiting a relatively large difference in respective refractive index to EUV light relative to the refractive index of a vacuum, and the second substance exhibiting a relatively small difference in relative refractive index to EUV light relative to the refractive index of a vacuum;
obtaining a profile of a reflected wave-front produced by reflection of the light from a surface of the multilayer film, and identifying from the profile a wave aberration requiring reduction; and
based on the obtained profile, at corresponding locations on a surface of the multilayer film, selectively removing at least one layer-set of the multilayer film in a manner yielding a smoothly connected corrected reflection wave-front.

**88.** A method according to claim 87, wherein, in the corresponding locations, each layer of the first material that is removed is provided with respective edges having a relatively steep inclination, and each layer of the second material that is removed is provided with respective edges having a relatively gentle inclination.

**89.** A method according to any one of claims 87 to 88, wherein:

in the corresponding locations, each layer of the first material that is removed is removed at a first removal rate, and each layer of the second material that is removed is removed at a second removal rate; and
a ratio of the first and second removal rates is equal to a ratio of an inverse of a difference between vacuum refractive indices of the respective materials and refractive indices of the materials so that the corrected reflection wave-front produced by a boundary of adjacent layers of the first and second materials is smoothly connected.

**90.** A multilayer-film mirror, manufactured by a method according to any one of claims 87 to 89.

**91.** An EUV optical system, comprising a multilayer-film mirror according to claim 90.

**92.** An EUV lithography apparatus, comprising an EUV optical system according to claim 91.

**93.** A multilayer-film mirror, comprising:

a mirror substrate defining a reflection surface; and
a multilayer film formed on the reflective surface, the multilayer film having a prescribed period length and being formed by laminating multiple layer-sets each comprising respective alternating layers of at least two types of substances having mutually different refractive indices for a wavelength of light with which the mirror is to be used, the multilayer film having a surface defining at least one location at which a respective portion of at least a topmost layer-set has been removed to reduce a wave aberration of light reflected from the multilayer-film mirror, the at least top-most layer-set being removed to yield corresponding layer edges in the location that are configured to produce a smoothly connected corrected reflection wave-front.

**94.** A multilayer-film mirror according to claim 93, wherein, in each corresponding location, each layer of the first material that is removed has respective edges that are relatively steeply inclined, and each layer of the second material that is removed has respective edges that are relatively gently inclined.

**95.** A multilayer-film mirror according to claim 93 or 94, wherein, in the corresponding locations, each layer of the first material that is removed has been removed at a first removal rate, and each layer of the second material that is removed has been removed at a second removal rate; and

a ratio of the first and second removal rates is equal to a ratio of an inverse of a difference between vacuum refractive indices of the respective materials and refractive indices of the materials so that the corrected reflection wave-front produced by a boundary of adjacent layers of the first and second materials is smoothly connected.

**96.** An EUV optical system, comprising a multilayer-film mirror according to any one of claims 93 to 95.

**97.** An EUV lithography apparatus, comprising an EUV optical system according to claim 96.

**98.** An EUV lithography apparatus, comprising:

an EUV source that produces an EUV beam;
an illumination-optical system situated optically downstream of the EUV source and configured to guide the EUV beam from the EUV source to a pattern-defining reticle; and
a projection-optical system situated optically downstream of the reticle and configured to guide the EUV beam from the reticle to a sensitive substrate;

wherein at least one of the illumination-optical system, the reticle, and the projection-optical system comprises a multilayer-film mirror according to any one of claims 93 to 95.

**99.** A microlithography step for use in a method for manufacturing a microelectronic device, comprising:

applying a resist to a surface of a lithographic substrate on which the microelectronic devices are formed; and
transfer-exposing a pattern from a reticle to a location on the lithographic substrate using an EUV lithography apparatus according to claim 23.

**100.** A microlithography step for use in a method for manufacturing a microelectronic device, comprising:

applying a resist to a surface of a lithographic substrate on which the microelectronic devices are formed; and
transfer-exposing a pattern from a reticle to a location on the lithographic substrate using an EUV lithography apparatus according to claim 23.

**101.** A microlithography step for use in a method for manufacturing a microelectronic device, comprising:

applying a resist to a surface of a lithographic substrate on which the microelectronic devices are formed; and
transfer-exposing a pattern from a reticle to a location on the lithographic substrate using an EUV lithography apparatus according to claim 29.

**102.** A microlithography step for use in a method for manufacturing a microelectronic device, comprising:

applying a resist to a surface of a lithographic substrate on which the microelectronic devices are formed; and

transfer-exposing a pattern from a reticle to a location on the lithographic substrate using an EUV lithography apparatus according to claim 52.

103. A microlithography step for use in a method for manufacturing a microelectronic device, comprising:

applying a resist to a surface of a lithographic substrate on which the microelectronic devices are formed; and transfer-exposing a pattern from a reticle to a location on the lithographic substrate using an EUV lithography apparatus according to claim 64.

104. A microlithography step for use in a method for manufacturing a microelectronic device, comprising:

applying a resist to a surface of a lithographic substrate on which the microelectronic devices are formed; and transfer-exposing a pattern from a reticle to a location on the lithographic substrate using an EUV lithography apparatus according to claim 72.

105. A microlithography step for use in a method for manufacturing a microelectronic device, comprising:

applying a resist to a surface of a lithographic substrate on which the microelectronic devices are formed; and transfer-exposing a pattern from a reticle to a location on the lithographic substrate using an EUV lithography apparatus according to claim 77.

106. A microlithography step for use in a method for manufacturing a microelectronic device, comprising:

applying a resist to a surface of a lithographic substrate on which the microelectronic devices are formed; and transfer-exposing a pattern from a reticle to a location on the lithographic substrate using an EUV lithography apparatus according to claim 86.

107. A microlithography step for use in a method for manufacturing a microelectronic device, comprising:

applying a resist to a surface of a lithographic substrate on which the microelectronic devices are formed; and transfer-exposing a pattern from a reticle to a location on the lithographic substrate using an EUV lithography apparatus according to claim 98.

108. A microelectronic device, produced by a method according to claim 99.

109. A microelectronic device, produced by a method according to claim 101.

110. A microelectronic device, produced by a method according to claim 102.

111. A microelectronic device, produced by a method according to claim 103.

112. A microelectronic device, produced by a method according to claim 104.

113. A microelectronic device, produced by a method according to claim 105.

114. A microelectronic device, produced by a method according to claim 106.

115. A microelectronic device, produced by a method according to claim 107.

FIG. 1

23

2b → ← 2b

22

21

24

FIG. 2(a)

24 23

21 22

FIG. 2(b)

11

EP 1 291 680 A2

FIG. 3

40

FIG. 4

FIG. 5

EP 1 291 680 A2

FIG. 6

43

```
┌─────────────────┐
│ Substrate       │
│ Processing      │
└─────────────────┘
         │
         ▼
┌─────────────────┐
│ Form Multilayer │
│ Film on Substrate│
└─────────────────┘
         │
         ▼
┌─────────────────┐        ┌──────────────────────┐
│ Assemble        │        │ Multilayer-film      │
│ Optical System  │        │ Correction Processing│
└─────────────────┘        └──────────────────────┘
         │                            ▲
         ▼                            │
┌─────────────────┐        ┌──────────────────────┐
│ Measure         │        │ Compute              │
│ Wave-front      │        │ Correction Amount    │
└─────────────────┘        └──────────────────────┘
         │                            ▲
         ▼                            │
    ╱─────────╲        No             │
   ╱ Wave-front ╲──────────────────────┘
   ╲ Aberration OK? ╱
    ╲─────────╱
         │ Yes
         ▼
┌─────────────────┐
│ Complete        │
└─────────────────┘
```

FIG. 7

FIG. 8

Surface Reflectivity of Mo and Si

FIG. 9

FIG. 10

FIG. 11

FIG. 12

EP 1 291 680 A2

FIG. 13

FIG. 14(a)

FIG. 14(b)

FIG. 15(a)    FIG. 15(b)    FIG. 15(c)

EP 1 291 680 A2

FIG. 16(a)

FIG. 16(b)

FIG. 17

FIG. 18

FIG. 19

```
┌─────────────────────────────────┐
│       Resist coating Step        │
└─────────────────────────────────┘
                 │
                 ▼
┌─────────────────────────────────┐
│          Exposure Step           │
└─────────────────────────────────┘
                 │
                 ▼
┌─────────────────────────────────┐
│      Resist developing Step      │
└─────────────────────────────────┘
                 │
                 ▼
┌─────────────────────────────────┐
│      Resist annealing Step       │
└─────────────────────────────────┘
```

## Lithography Step

FIG. 20

FIG. 21(a)

PRIOR ART

FIG. 21(b)

PRIOR ART